# EUROPEAN PATENT SPECIFICATION

(11) **EP 4 686 342 B1**
(45) Date of publication and mention of the grant of the patent: **25.11.2026**
(21) Application number: 25189573.6
(22) Date of filing: 15.07.2025
(51) Int. Cl.: H10D 30/67, H10D 86/40

(54) **THIN FILM TRANSISTOR, METHOD FOR MANUFACTURING THE SAME AND DISPLAY APPARATUS COMPRISING THE SAME**
DÜNNFILMTRANSISTOR, VERFAHREN ZU SEINER HERSTELLUNG UND EINE IHN ENTHALTENDE ANZEIGEVORRICHTUNG
TRANSISTOR À COUCHE MINCE, PROCÉDÉ DE FABRICATION ET APPAREIL D'AFFICHAGE LE COMPRENANT

(30) Priority: 24.07.2024 KR 20240098157
(43) Date of publication of application: 28.01.2026
(73) Proprietor: LG Display Co., Ltd., Seoul, 07336 (KR)
(72) Inventor: CHO, HyunCheol, 10845 Paju-si (KR); JEONG, ChanYong, 10845 Paju-si (KR); LEE, Minho, 10845 Paju-si (KR)
(74) Representative: Ter Meer und Partner mbB

(56) References cited:
- EP-A1- 4 394 892
- US-A1- 2014 103 346
- US-A1- 2014 175 423
- US-A1- 2018 190 830
- US-A1- 20240 136 362

## Description

This application claims the benefit of priority of the Republic of Korea Patent Application No. 10-2024-0098157 filed on July 24, 2024.

### BACKGROUND

### Field of Technology

The present disclosure relates to a thin film transistor having a seed layer, a method for manufacturing the thin film transistor, and a display apparatus including the thin film transistor.

### Discussion of the Related Art

The transistors are widely used as switching devices or driving device in the field of electronic devices. In particular, thin film transistors are widely used as switching devices in display apparatuses such as liquid crystal display devices or organic light emitting devices because they may be manufactured on glass or plastic substrates.

Thin film transistors may be classified into amorphous silicon thin film transistors in which amorphous silicon is operated as the active layer, polycrystalline silicon thin film transistors in which polycrystalline silicon is used as the active layer, and oxide semiconductor thin film transistors in which oxide semiconductor is used as the active layer, based on the material constituting the active layer.

Since amorphous silicon may be deposited in a short period of time to form an active layer, amorphous silicon thin film transistors (a-Si TFTs) have the advantages of a short manufacturing process time and low production costs. On the other hand, amorphous silicon thin film transistors have the disadvantages of limited use in active matrix organic light emitting diodes (AMOLED) because of low mobility, poor current driving capability, and changes in threshold voltage.

Polycrystalline silicon thin film transistors (poly-Si TFT) are made by crystallizing amorphous silicon after amorphous silicon has been deposited. Polycrystalline silicon thin film transistors have the advantages of high electron mobility, excellent stability, thinness, high resolution, and high power efficiency. Examples of such polycrystalline silicon thin film transistors include low-temperature poly-silicon (LTPS) thin film transistors, or polysilicon thin film transistors. Since the manufacturing process of polycrystalline silicon thin film transistors requires a process in which amorphous silicon is crystallized, the number of processes increases, which increases the manufacturing cost, and crystallization must be performed at a high process temperature.

Oxide semiconductor thin film transistors that have high mobility and a large resistance variation depending on the oxygen content have the advantage of being able to easily obtain desired property. In addition, since the oxide constituting the active layer may be formed at a relatively low temperature during the manufacturing process of oxide semiconductor thin film transistors, the manufacturing cost is low. Since oxide semiconductors are transparent due to the nature of oxides, they are also advantageous in implementing transparent displays.

However, the performance of oxide semiconductor thin film transistors may be degraded and the turn-on voltage may become unstable due to hydrogen. In particular, when the oxide semiconductor thin film transistor is used in an environment containing a large amount of hydrogen or at a high temperature, the performance deterioration or performance instability due to hydrogen may become severe.

Therefore, in order to prevent deterioration of oxide thin film transistors and to improve stability, it is necessary to protect oxide semiconductor thin film transistors from hydrogen. Each one of US 2024/136362 A1, US 2014/103346, US 2014/175423 A1, US 2018/190830 A1 relates to a thin film transistor having the features of the preamble of the independent claim 1.

### SUMMARY

One object of the present disclosure is to provide a thin film transistor including a seed layer and an active layer contacting the seed layer.

One object of the present disclosure is to provide a thin film transistor having excellent resistance to hydrogen, due to having a channel part crystallized by a seed layer.

One object of the present disclosure provides a thin film transistor in which an active layer may be formed of an oxide semiconductor layer having conductor property, and the channel part may be crystallized by a seed layer to have a semiconductor property.

One object of the present disclosure provides a thin film transistor in which a channel part may have a crystalline structure and a connection part may have an amorphous structure.

One object of the present disclosure provides a manufacturing method for a thin film transistor, which is manufactured using an oxide semiconductor material having conductor property and thus does not require a conductorization process.

Another object of the present disclosure provides a manufacturing method for a thin film transistor using an oxide semiconductor material having conductor property and a seed layer.

Another object of the present disclosure provides a display apparatus having excellent reliability, including a thin film transistor as described above.

At least one of these objects and an object that one skilled in the art may derive thereform is solved by a thin film transistor, a display apparatus, and/or a manufacturing method of the thin film transistor as set out in the independent claims. Further embodiments are specified in the respective dependent claims.

According to one aspect of the present disclosure, a thin film transistor comprises, inter alia: a seed layer having an amorphous structure; an active layer overlapping the seed layer and including a channel part, the channel part contacting the seed layer and having a crystalline structure; and a gate electrode overlapping the seed layer and at least a portion of the active layer in a planar view of the thin film transistor.

According to another aspect of the present disclosure, a manufacturing method of a thin film transistor comprises, inter alia: forming a seed layer on a substrate; forming an active layer overlapping the seed layer such that a portion of the active layer is in contact with the seed layer and another portion of the active layer is not in contact with the seed layer; crystallizing the portion of the active layer that contacts the seed layer by heat treating the active layer; and forming a gate electrode on the active layer.

According to another aspect of the present disclosure, a thin film transistor comprises: a seed layer including a first oxide semiconductor material; an active layer comprising a second oxide semiconductor material, the active layer including a channel part that covers an upper surface and side surfaces of the seed layer, a first connection part at a first side of the channel part, and a second connection part at a second side of the channel part that is opposite the first side of the channel part; and a gate electrode overlapping the seed layer and the channel part such that the channel part is between the seed layer and the gate electrode, wherein a first carrier concentration of the first oxide semiconductor material of the seed layer is less than a second carrier concentration of the second oxide semiconductor material of the active layer and a first oxygen concentration of the first oxide semiconductor material is greater than a second oxygen concentration of the second oxide semiconductor material.

According to another aspect of the present disclosure, a display apparatus comprises the thin film transistor according to an aspect of the present disclosure.

At least one of the thin film transistors, the manufacturing method thereof, and/or the display device may further comprise at least one of the following features:

The channel part may be between the seed layer and the gate electrode.

The active layer may include a first connection part connected to a first side of the channel part and a second connection part connected to a second side of the channel part. The second side of the channel part maybe opposite to the first side of the channel part. The first connection part and/or the second connection part may have an amorphous structure that is different from the crystalline structure of the channel part.

A length of the seed layer is less than a length of the gate electrode along a first direction. The first direction may be a direction that is parallel to a substrate of the display apparatus. The first direction may be a length direction.

A width of the seed layer may be greater than a width of the active layer along a second direction that is different from the first direction. The second direction may be a direction that is parallel to the substrate of the display apparatus. The second direction may be perpendicular to the first direction. The second direction may be a width direction.

A carrier concentration of the seed layer may be less than at least one of a carrier concentration of the channel part, a carrier concentration of the first connection part, and a carrier concentration of the second connection part.

The carrier concentration of the seed layer may be 1.0 × 10¹⁶ 1/cm³ or less.

A thickness of the seed layer may be in a range of 1 nm to 10 nm.

The amorphous structure of the seed layer may include crystals having a grain size of 1 nm or more. A ratio of a sum of areas of the crystals having the grain size of 1 nm or more is 10 % or less may be based on an entire cross-sectional area of the seed layer. In other words, 10% or less of the entire cross-sectional area of the seed layer may be formed by crystals having the grain size of 1nm or less.

The seed layer may include at least one of indium zinc oxide (InZnO) based oxide semiconductor material, indium gallium zinc oxide IGZO (InGaZnO) based oxide semiconductor material, indium gallium zinc tin oxide (InGaZnSnO) based oxide semiconductor material, gallium zinc tin oxide (GaZnSnO) based oxide semiconductor material, gallium zinc oxide (GaZnO) based oxide semiconductor material, and gallium oxide (GaO) based oxide semiconductor material.

The active layer may include at least one of indium gallium zinc oxide (InGaZnO) based, indium gallium oxide (InGaO) based, indium gallium zinc tin oxide (InGaZnSnO) based, gallium zinc tin oxide (GaZnSnO) based, gallium zinc oxide (GaZnO) based, gallium oxide (GaO) based, tin oxide (SnO) based, indium tin oxide (InSnO) based, indium tin zinc oxide (InSnZnO) based, indium zinc oxide (InZnO) based, zinc oxide (ZnO) based, indium oxide (InO) based, zinc oxide (ZnO) based, and iron indium zinc oxide (FeInZnO) based oxide semiconductor materials.

The active layer may further include at least one of beryllium (Be), boron (B), carbon (C), aluminum (Al), silicon (Si), iron (Fe), calcium (Ca), tin (Sn), titanium (Ti), tantalum (Ta), vanadium (V), yttrium (Y), and zirconium (Zr).

The seed layer and the active layer may include at least one same metal element.

In the channel part, a ratio of a sum of areas of crystals having a grain size of 1 nm or more may be 50 % or more based on an entire cross-sectional area of the channel part. In other words, 50% or more of the entire cross-sectional area of the seed layer may be formed by crystals having the grain size of 1nm or more.

The crystalline structure of the channel part may include at least one of a (400) crystal plane, a (222) crystal plane, a (220) crystal plane, a (311) crystal plane, or a (001) crystal plane.

The seed layer may include a first pattern and a second pattern. The first patter and the second pattern may be spaced apart from each other. The first patter and the second pattern may overlap the gate electrode. The active layer may be between the first pattern and the second pattern. The active layer may be in contact with the first pattern and the second pattern.

The channel part may include a first channel contacting the first pattern and a second channel contacting the second pattern.

The seed layer may have at least one via hole that overlaps the gate electrode. A portion of the active layer may be disposed in the at least one via hole.

The active layer may include a first oxide semiconductor layer. The active layer may include a second oxide semiconductor layer on the first oxide semiconductor layer. The seed layer may be between the first oxide semiconductor layer and second oxide semiconductor layer. The seed layer may contact the first oxide semiconductor layer and the second oxide semiconductor layer.

The active layer may have an amorphous structure in the forming of the active layer. The portion of the active layer contacting the seed layer may be transformed into a crystalline structure by the heat treating.

A thickness of the seed layer may be 1 nm to 10 nm. A temperature of the heat treating may be in a range of 300 °C to 500 °C.

Forming the seed layer may comprise performing a heat treatment under conditions satisfying an Equation 1: [Equation 1] Y = 22.2x + 277.8, where "x" may denote a thickness the seed layer in nm and a temperature of the heat treating may be "Y" in °C.

The channel part may be in direct contact with the upper surface and the side surfaces of the seed layer.

The channel part may have a crystalline structure. The first connection part, the second connection part, and/or the seed layer may have an amorphous structure.

The seed layer may include a first pattern and a second pattern that are spaced apart from each other. The first pattern and the second pattern may overlap the gate electrode. The active layer may be between the first pattern and the second pattern. The active layer may be in contact with the first pattern and the second pattern.

The channel part may include: a first channel contacting the first pattern; and a second channel contacting the second pattern.

The seed layer may have at least one via hole. that the via hole may overlap the gate electrode. A portion of the active layer may be disposed in the at least one via hole.

The active layer may include a plurality of semiconductor layers. The seed layer may be disposed between the plurality of semiconductor layers.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a plan view of a thin film transistor according to one embodiment of the present disclosure.
FIG. 2 is a cross-sectional view taken along line I-I' of FIG. 1 according to one embodiment of the present disclosure.
FIG. 3 is a cross-sectional view taken along line II-II' of FIG. 1 according to one embodiment of the present disclosure.
FIG. 4 is a cross-sectional view of a thin film transistor according to another embodiment of the present disclosure.
FIG. 5 is a cross-sectional view of a thin film transistor according to another embodiment of the present disclosure.
FIG. 6 is a cross-sectional view of a thin film transistor according to another embodiment of the present disclosure.
FIG. 7 is a plan view of a thin film transistor according to another embodiment of the present disclosure.
FIG. 8 is a cross-sectional view taken along line III-III' of FIG. 7 according to one embodiment of the present disclosure.
FIG. 9 is a plan view of a thin film transistor according to another embodiment of the present disclosure.
FIG. 10 is a cross-sectional view taken along line IV-IV' of FIG. 9 according to one embodiment of the present disclosure.
FIG. 11 is a plan view of a thin film transistor according to another embodiment of the present disclosure.
FIG. 12 is a cross-sectional view taken along line V-V' of FIG. 11 according to one embodiment of the present disclosure.
FIG. 13 is a cross-sectional view of a thin film transistor according to another embodiment of the present disclosure.
FIG. 14 is a plan view of a thin film transistor according to another embodiment of the present disclosure.
FIG. 15 is a cross-sectional view taken along line VI-VI' of FIG. 14 according to one embodiment of the present disclosure.
FIG. 16 is a cross-sectional view taken along line VII-VII' of FIG. 14 according to one embodiment of the present disclosure.
FIG. 17 is a plan view of a thin film transistor according to another embodiment of the present disclosure.
FIG. 18 is a cross-sectional view taken along line VIII-VIII' of FIG. 17 according to one embodiment of the present disclosure.
FIG. 19 is a plan view of a thin film transistor according to another embodiment of the present disclosure.
FIG. 20 is a cross-sectional view of a thin film transistor according to another embodiment of the present disclosure.
FIG. 21 is a cross-sectional view of a thin film transistor according to another embodiment of the present disclosure.
FIGs. 22A to 22E are cross-sectional views illustrating a method for manufacturing a thin film transistor according to one embodiment of the present disclosure.
FIG. 23 is a schematic diagram of a display apparatus according to another embodiment of the present disclosure.
FIG. 24 is a circuit diagram for one pixel of FIG. 23 according to one embodiment of the present disclosure.
FIG. 25 is a plan view of the pixel of FIG. 24 according to one embodiment of the present disclosure.
FIG. 26 is a cross-sectional view taken along line IX-IX' of FIG. 25 according to one embodiment of the present disclosure.

### DETAILED DESCRIPTION

The advantages and features of the present disclosure, and the method for achieving them, will become clear with reference to the embodiments described in detail below together with the accompanying drawings. However, the present disclosure is not limited to the embodiments disclosed below, and may be implemented in various other forms. These embodiments are provided to ensure that the disclosure of the present disclosure is complete, and to enable those skilled in the art to easily understand the invention.

The shapes, sizes, ratios, angles, numbers, etc. disclosed in the drawings for explaining embodiments of the present disclosure are exemplary, and the present disclosure is not limited to the matters illustrated in the drawings. The same components may be referred to by the same reference numerals throughout the specification. In addition, in explaining the present disclosure, if it is determined that a detailed description of a related known technology may unnecessarily obscure the gist of the present disclosure, the detailed description is omitted.

In this specification, when the words "includes," "has," and "comprising," are used, other parts may be added unless the expression "only" is used. When a component is expressed in the singular, the plural is included unless otherwise explicitly stated.

When interpreting a component, it is interpreted as including the error range even though there is no separate explicit description.

When describing a positional relationship, for example, when the positional relationship between two parts is described as 'on', 'above', 'below', 'next to', etc., one or more other parts may be located between the two parts, unless the expression 'right' or 'directly' is used.

The spatially relative terms "below," "beneath," "lower," "above," "upper," and the like may be used to easily describe the relationship of one element or component to another element or component, as illustrated in the drawings. The spatially relative terms should be understood to include different orientations of the elements during use or operation in addition to the orientations depicted in the drawings. For example, if an element illustrated in the drawings is flipped over, an element described as "below" or "beneath" another element may end up being placed "above" the other element. Thus, the exemplary term "below" can include both the above and below directions. Likewise, the exemplary term "above" or "above" can include both the above and below directions.

When describing a temporal relationship, for example, when describing a temporal relationship such as 'after', 'following', 'next to', 'before', etc., it can also include cases where it is not continuous, as long as the expression 'right away' or 'directly' is not used.

Although the terms first, second, etc. are used to describe various components, these components are not limited by these terms. These terms are only used to distinguish one component from another. Accordingly, a first component referred to below may also be a second component within the technical concept of the present disclosure.

At least one term should be understood to include all combinations that may be presented from one or more of the associated items. For example, the meaning of "at least one of the first, second, and third items" can mean not only each of the first, second, or third items, but also all combinations of items that may be presented from two or more of the first, second, and third items.

The individual features of the various embodiments of the present disclosure may be partially or wholly combined or combined with each other, and may be technically linked and driven in various ways, and each embodiment may be implemented independently of each other or may be implemented together in a related relationship.

Hereinafter, a thin film transistor according to an embodiment of the present disclosure and a display apparatus including the same will be described in detail with reference to the attached drawings. When identifying reference symbols to components in each drawing, the same components may be represented by the same symbols as much as possible even though they are shown in different drawings.

In embodiments of the present disclosure, the source electrode and the drain electrode are distinct, but the source electrode and the drain electrode may be exchanged each other. For example, a source electrode according to one embodiment may become a drain electrode in another embodiment, and a drain electrode according to one embodiment may become a source electrode in another embodiment.

In the embodiments of the present disclosure, for the convenience of explanation, the source region and the source electrode are distinguished, and the drain region and the drain electrode are distinguished, but the embodiments of the present disclosure are not limited thereto. The source region may be the source electrode, and the drain region may be the drain electrode. In addition, the source region may be the drain electrode, and the drain region may be the source electrode.

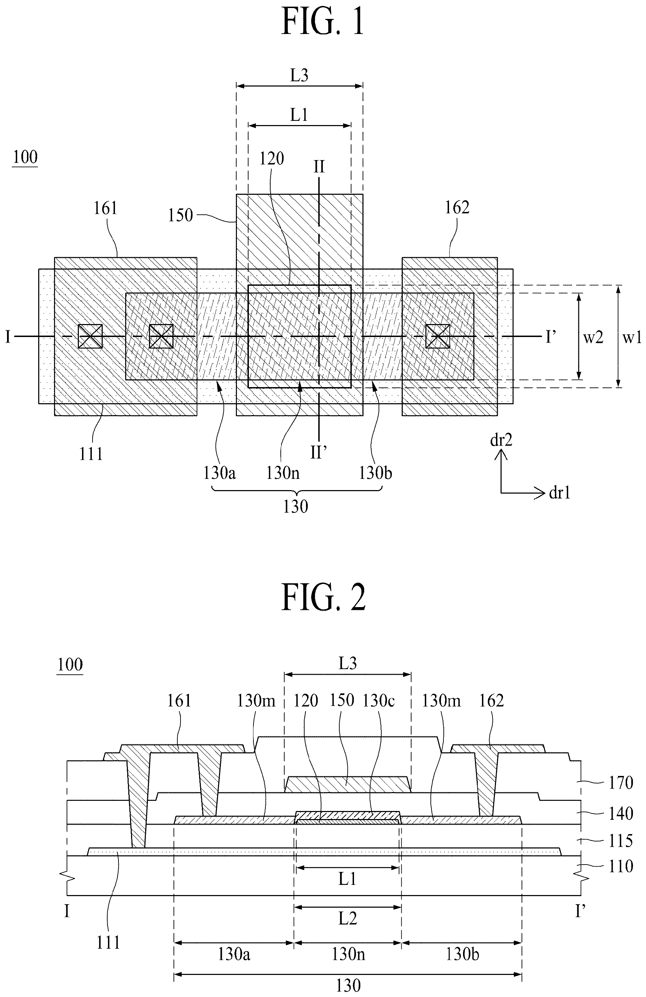

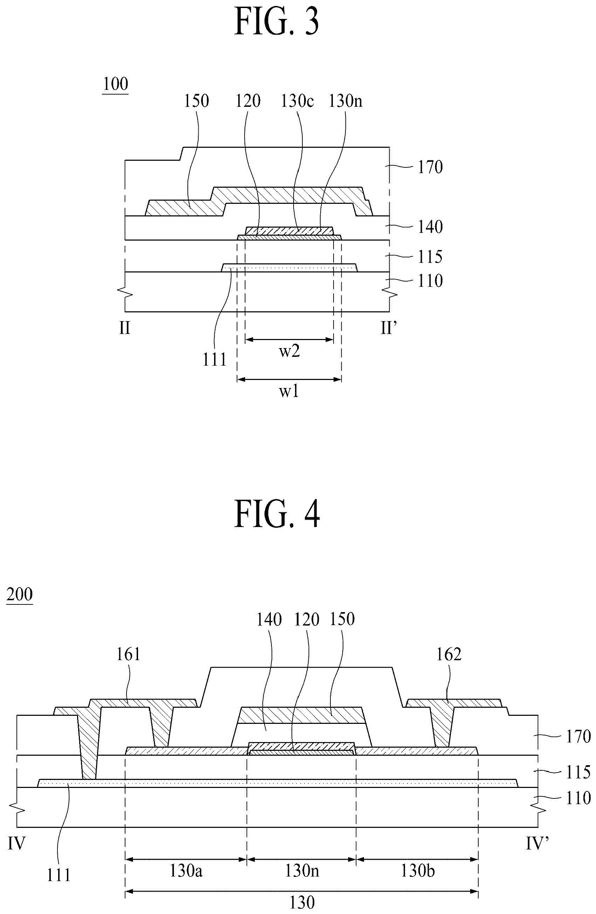

FIG. 1 is a plan view of a thin film transistor 100 according to one embodiment of the present disclosure, FIG. 2 is a cross-sectional view taken along line I-I' of FIG. 1 according to one embodiment of the present disclosure, and FIG. 3 is a cross-sectional view taken along line II-II' of FIG. 1 according to one embodiment of the present disclosure.

A thin film transistor 100 according to one embodiment of the present disclosure includes a seed layer 120, an active layer 130 overlapping the seed layer 120, and a gate electrode 150 overlapping at least a part of the active layer 130. The active layer 130 includes a channel part 130n. In addition, the active layer 130 may include a first connection part 130a connected to a first side of the channel part 130n and a second connection part 130b connected to a second side of the channel part 130n that is opposite the first side of the channel part 130n. The channel part 130n overlaps the seed layer 120 and the gate electrode 150.

Referring to FIGs. 2 and 3, a thin film transistor 100 may be disposed on a substrate 110. Anything that supports the thin film transistor 100 may be referred to as a substrate 110 without limitation.

Glass or plastic may be used as the substrate 110. A transparent plastic having flexible property may be used as the substrate 110. Among the plastics, for example, when polyimide is used as the substrate 110, considering that a high-temperature deposition process is performed on the substrate 110, a heat-resistant polyimide that can withstand high temperatures may be used.

A light shielding layer 111 may be disposed on the substrate 110. The light shielding layer 111 overlaps the channel part 130n. The light shielding layer 111 blocks light incident from the outside, thereby protecting the channel part 130n.

The light shielding layer 111 may be made of a material having light blocking property. The light shielding layer 111 may include at least one of an aluminum based metal such as aluminum (Al) or an aluminum alloy, a molybdenum based metal such as molybdenum (Mo) or a molybdenum alloy, chromium (Cr), tantalum (Ta), neodymium (Nd), titanium (Ti), and iron (Fe). According to one embodiment of the present disclosure, the light shielding layer 111 may have electrical conductivity.

The light shielding layer 111 may be electrically connected to either the source electrode 161 or the drain electrode 162. The light shielding layer 111 may also be connected to the gate electrode 150. The light shielding layer 111 may be omitted in other embodiments.

A buffer layer 115 is disposed on the light shielding layer 111. The buffer layer 115 may be made of an insulating material. For example, the buffer layer 115 may include at least one of insulating materials such as silicon oxide, silicon nitride, and metal oxide. The buffer layer 115 may have a single film structure or a multi film structure.

The buffer layer 115 may protect the active layer 130 by blocking air and moisture. In addition, the surface of the upper portion of the substrate 110 on which the light shielding layer 111 is disposed may be made uniform by the buffer layer 115.

The seed layer 120 may be disposed on the substrate 110. Referring to FIG. 2, the seed layer 120 may be disposed on the buffer layer 115.

The seed layer 120 may have a function of selectively crystallizing a portion of the active layer 130 that contacts the seed layer 120. The seed layer 120 can act as a seed for crystal growth. A selected portion of the active layer 130 may be crystallized by the seed layer 120. As a result, a portion of the active layer 130 may have crystal properties. That is, at least a portion of the active layer 130 may form a crystalline structure.

According to one embodiment of the present disclosure, the seed layer 120 may include an oxide semiconductor material.

For example, the seed layer 120 may include at least one of an IZO (InZnO) based oxide semiconductor material, an IGZO (InGaZnO) based oxide semiconductor material, an IGZTO (InGaZnSnO) based oxide semiconductor material, a GZTO (GaZnSnO) based oxide semiconductor material, a GZO (GaZnO) based oxide semiconductor material, and a GO (GaO) based oxide semiconductor material.

The seed layer 120 selectively crystallizes the active layer 130 and does not affect the electrical characteristic of the active layer 130.

According to one embodiment of the present disclosure, the seed layer 120 has a basic composition made of an oxide semiconductor material, but includes a large amount of oxygen. As a result, the seed layer 120 may have the characteristic of an insulating layer in terms of electrical property.

In detail, the seed layer 120 may be formed by an oxide semiconductor material having a low carrier concentration and a high oxygen concentration. The seed layer 120 according to one embodiment of the present disclosure may have a high resistivity. The seed layer 120 having a high resistivity has electrical characteristic similar to an insulator and does not participate in the carrier movement of the active layer 130. In one embodiment of the present disclosure, the seed layer 120 may not affect the carrier movement of the active layer 130. According to one embodiment of the present disclosure, the seed layer 120 has a lower carrier concentration than the channel part 130n, the first connection part 130a, and the second connection part 130b.

According to one embodiment of the present disclosure, the seed layer 120 may have a carrier concentration of 1.0 x 10¹⁶ea/cm³ or less. When the carrier concentration of the seed layer 120 is 1.0 x 10¹⁶ea/cm³ or less, the seed layer 120 may have electrical characteristic similar to an insulating layer.

According to one embodiment of the present disclosure, the seed layer 120 has a carrier concentration of 1.0 x 10¹⁶ea/cm³ or less, which is comparably a low carrier concentration, and thus has insulating property. Accordingly, the seed layer 120 may not affect the ON current characteristic of the thin film transistor 100.

According to one embodiment of the present disclosure, the seed layer 120 may have a thickness of 1 nm to 10 nm. In order not to affect the electrical characteristic of the active layer 130, the seed layer 120 may have a thin thickness of 10 nm or less.

Even though the seed layer 120 has a low carrier concentration, when the thickness of the seed layer 120 is large, there is a possibility that a flow of charges through the seed layer 120 may occur. For example, when the thickness of the seed layer 120 increases, an electron-hole pair may be formed in the seed layer 120, causing the seed layer 120 to exhibit semiconductor characteristic. When the seed layer 120 has a semiconductor characteristic, it may not be easy to control the electrical characteristic of the thin film transistor 100.

Since variations may occur in the carrier movement of the thin film transistor 100 when the thickness of the seed layer 120 exceeds 10 nm, according to one embodiment of the present disclosure, the seed layer 120 is designed to have a thickness of 10 nm or less.

Meanwhile, when the thickness of the seed layer 120 is less than 1 nm, the seed layer 120 may not function as a seed for crystal growth due to the thin thickness. In addition, when the thickness of the seed layer 120 is designed to be less than 1 nm, the seed layer 120 may be easily damaged due to the thin thickness, and the mechanical stability of the seed layer 120 may be deteriorated. Therefore, according to one embodiment of the present disclosure, the thickness of the seed layer 120 may be designed to be 1 nm or more.

The seed layer 120 has an amorphous structure. According to one embodiment of the present disclosure, the seed layer 120 is an amorphous layer.

According to one embodiment of the present disclosure, in a cross-sectional surface of a layer, when the ratio of a sum of areas of crystals having a crystal grain size of 1 nm or more is 10% or less to the entire area of the cross-sectional surface, the layer is referred to as an amorphous layer. In detail, in a transmission electron microscope TEM image of a cross-section of a layer to be measured, when the ratio of a sum of areas of crystals having a crystal grain size of 1 nm or more is 10% or less to the entire area of the cross-section, the layer is referred to as an amorphous layer.

According to one embodiment of the present disclosure, the seed layer 120 is an amorphous layer in which the proportion of the sum of areas of crystals having a crystal grain size of 1 nm or more is 10% or less to the entire cross-sectional area based on the cross-sectional surface of the seed layer 120.

On the other hand, if the ratio of the sum of areas of crystals having a grain size of 1 nm or more is 50% or more to the entire cross-sectional area, the layer is referred to as a crystalline layer. In detail, in a transmission electron microscope TEM image of a cross-section of a layer to be measured, if the ratio of the sum of areas of crystals having a grain size of 1 nm or more is 50% or more to the entire cross-sectional area, the layer is referred to as a crystalline layer.

Referring to FIGs. 2 and 3, an active layer 130 is disposed on a seed layer 120.

According to one embodiment of the present disclosure, the active layer 130 may be formed of a semiconductor material. The active layer 130 may include an oxide semiconductor material. The active layer 130 may include, for example, an oxide semiconductor layer.

In FIG. 1 to FIG. 3, a thin film transistor 100 in which the active layer 130 is an oxide semiconductor layer is illustrated as an example.

According to one embodiment of the present disclosure, the active layer 130 may be formed by an oxide semiconductor material having a high mobility similar to that of a conductor. For example, the active layer 130 may be formed by an amorphous oxide semiconductor material having a carrier concentration of 1.0 x 10¹⁹ea/cm³ or more. On the other hand, the seed layer 120 may be formed by an amorphous oxide semiconductor material having a carrier concentration lower than a carrier concentration of the active layer 130.

The active layer 130 may include, for example, at least one of an IGZO (InGaZnO) based oxide semiconductor material, an IGO (InGaO) based oxide semiconductor material, an IGZTO (InGaZnSnO) based oxide semiconductor material, a GZTO (GaZnSnO)based oxide semiconductor material, a GZO (GaZnO) based oxide semiconductor material, a GO (GaO) based oxide semiconductor material, a TO (SnO) based oxide semiconductor material, an ITO (InSnO) based oxide semiconductor material, an ITZO (InSnZnO) based oxide semiconductor material, an indium zinc oxide based (InZnO) based oxide semiconductor material, a zinc oxide (ZnO) based oxide semiconductor material, an indium oxide (InO) based oxide semiconductor material, a ZnO based oxide semiconductor material, and an iron indium zinc oxide (FeInZnO) based oxide semiconductor material. However, one embodiment of the present disclosure is not limited thereto, and other conventional oxide semiconductor materials having high mobility may be applied to the active layer 130 according to one embodiment of the present disclosure.

According to one embodiment of the present disclosure, an indium-based oxide semiconductor material comprising 50 atomic % (at %) or more of indium (In) atoms based on the total number of the metal atoms may be used as an oxide semiconductor material for forming an active layer 130. The active layer 130 may include, for example, at least one of an IZO (InZnO) based oxide semiconductor material, an IGO (InGaO) based oxide semiconductor material, an IGZO (InGaZnO) based oxide semiconductor material, an ITO (InSnO) based oxide semiconductor material, and an IGZTO (InGaZnSnO) based oxide semiconductor material, in which an indium (In) content is 50 atomic % (at %) or more based on the total number of metal atoms.

In detail, the active layer 130 may include an IZO based oxide semiconductor material having an indium (In) content of 50 atomic % or more of the total content of indium (In) and zinc (Zn), an IGO based oxide semiconductor material having an indium (In) content of 70 atomic % or more to the total content of indium (In) and gallium (Ga), an IGZO based oxide semiconductor material having an indium (In) content of 50 atomic % or more to the total content of indium (In), gallium (Ga), and zinc (Zn), an ITO based oxide semiconductor material having an indium (In) content of 80 atomic % or more to the total content of indium (In) and tin (Sn), and an IGZTO based oxide semiconductor material having a mixed content of indium (In) and tin (Sn) of 50 atomic % or more to the total content of indium (In), gallium (Ga), zinc (Zn), and tin (Sn).

According to one embodiment of the present disclosure, the active layer 130 may have a low oxygen concentration.

When the active layer 130 contains a high concentration of indium (In) and a low concentration of oxygen, the active layer 130 may have high mobility characteristic and excellent electrical conductivity.

According to one embodiment of the present disclosure, the active layer 130 may include at least one of beryllium (Be), boron (B), carbon (C), aluminum (Al), silicon (Si), iron (Fe), calcium (Ca), tin (Sn), titanium (Ti), tantalum (Ta), vanadium (V), yttrium (Y), and zirconium (Zr). The above elements may be dispersed in the oxide semiconductor material.

According to one embodiment of the present disclosure, beryllium (Be), boron (B), carbon (C), aluminum (Al), silicon (Si), iron (Fe), calcium (Ca), tin (Sn), titanium (Ti), tantalum (Ta), vanadium (V), yttrium (Y), or zirconium (Zr) may be referred to as a crystallization controlling element.

The crystallization control element is an element that has a strong bonding affinity with oxygen and may delay the crystallization of the active layer 130. The active layer 130 may be formed by deposition and patterning, and the crystallization control element prevents crystallization of the active layer 130 during the deposition process, thereby prevents the deterioration of patterning property of the active layer 130.

On the other hand, crystallization control element does not completely prevent crystallization of the active layer 130. As a result, when a heat treatment is performed in a state that the active layer 130 contacts the seed layer 120, a portion of the active layer 130 contacting the seed layer 120 may be crystallized.

According to one embodiment of the present disclosure, the crystallization control element may have a content of 0.1 to 6 atomic % (at %) with respect to the total atoms of the active layer 130 excluding oxygen atom. When the content of the crystallization control element is less than 0.1 atomic % (at %) with respect to the total atoms of the active layer 130 excluding oxygen atom, the crystallization prevention effect may not be sufficient during the deposition process. As a result, difficulty may occur during the patterning process after deposition of the oxide semiconductor material for forming the active layer 130.

On the other hand, if the content of the crystallization control element exceeds 6 atomic % (at %) with respect to the total atoms of the active layer 130 excluding oxygen atom, a selected portion of the active layer 130, for example, which contacts the seed layer 120, may not be crystallized or the crystallization rate may be reduced due to the excessive amount of the crystallization control element.

According to one embodiment of the present disclosure, the active layer 130 and the seed layer 120 may include one or more identical metal elements. When the active layer 130 and the seed layer 120 include the same element, the bonding strength between the active layer 130 and the seed layer 120 may be improved.

According to one embodiment of the present disclosure, the active layer 130 includes a channel part 130n. The channel part 130n is in direct contact with the seed layer 120. In addition, the channel part 130n overlaps the seed layer 120 and the gate electrode 150 such that the channel part 130n is between the seed layer 120 and the gate electrode 150.

According to one embodiment of the present disclosure, the channel part 130n has a crystalline structure.

According to one embodiment of the present disclosure, after an active layer 130 is formed by an amorphous oxide semiconductor material, a region of the active layer 130 overlapping with the seed layer 120 may be crystallized, thereby forming a channel part 130n. The channel part 130n may be referred to as a portion 130c of the active layer 130 that is crystallized by the seed layer 120.

According to one embodiment of the present disclosure, a change, i. e. a phase transition, from an amorphous structure to a crystalline structure is referred to as "crystallization". In addition, a crystallization of a specific portion of the active layer 130 is referred to as "selective crystallization". The crystallization of a specific portion of the active layer 130 may be also understood as local or localized crystallization.

According to one embodiment of the present disclosure, the channel part 130n may be referred to as a portion 130c selectively crystallized by the seed layer 120 in the active layer 130.

For example, selective crystallization of the active layer 130 may occur when oxygen contained in the seed layer 120 diffuses to the active layer 130 contacting with the seed layer 120. The seed layer 120 acts as a seed for crystallization. Using the seed layer 120 as a seed, crystallization can proceed from a portion of the active layer 130 that contacts the seed layer 120.

In the process of the selective crystallization of the active layer 130 contacting the seed layer 120 to form the channel part 130n, movement of oxygen O may occur. Oxygen O may move from the seed layer 120 to the channel part 130n. As a result, the channel part 130n may have a higher oxygen concentration than the first connection part 130a and the second connection part 130b. However, the oxygen concentration of the channel part 130n does not become same or higher than the oxygen concentration of the seed layer 120.

According to one embodiment of the present disclosure, the channel part 130n has an oxygen concentration that is less than an oxygen concentration of the seed layer 120. The oxygen concentration may be expressed in or calculated as atomic % (at %).

According to one embodiment of the present disclosure, the active layer 130 includes a first connection part 130a and a second connection part 130b. The first connection part 130a is connected to the side of the channel part 130n, and the second connection part 130b is connected to the second side of the channel part 130n.

The portion of the active layer 130 that contacts the seed layer 120 and its surroundings may be crystallized to become a channel part 130n, and the portion that does not contact the seed layer 120 may become a first connection part 130a and a second connection part 130b. Thus, the seed layer 120 does not contact the first connection part 130a and the second connection part 130B because the channel part 130n covers the seed layer 120.

The region of the active layer 130 that does not contact the seed layer 120 may maintain an amorphous state and also maintain a high carrier concentration. The amorphous portion 130m of the active layer 130 may become the first connection part 130a and the second connection part 130b. The channel part 130n may have a higher oxygen concentration than the first connection part 130a and the second connection part 130b.

The first connection part 130a and the second connection part 130b are non-crystallized portions. According to one embodiment of the present disclosure, the first connection part 130a and the second connection part 130b may have excellent electrical conductivity similar to that of metal.

The channel part 130n has a lower carrier concentration than the first connection part 130a and the second connection part 130b. In addition, the channel part 130n has a lower mobility than the first connection part 130a and the second connection part 130b.

Referring to FIG. 2, a channel part 130n may be formed on the upper surface of the seed layer 120 and on the side surface of the seed layer 120. Thus, the channel part 130n contact the upper surface and the side surfaces of the seed layer 120. In detail, portions of the active layer 130 that contact the upper surface of the seed layer 120 and the side surface of the seed layer 120 may be crystallized to become the channel part 130n. Accordingly, the length L2 of the channel part 130n may be longer than the length L1 of the seed layer 120. Here, the length is measured along a line connecting the first connection part 130a and the second connection part 130b. Referring to FIG. 1, the length is a distance measured along a direction dr1 connecting the first connection part 130a and the second connection part 130b.

However, since the thickness of the seed layer 120 is very thin, the portion of the active layer 130 that contacts the side surface of the seed layer 120 is very small. Therefore, the portion of the active layer 130 that contact the side surface of the seed layer 120 and is crystallized may be ignored. In this case, the channel part 130n may have the same length as the seed layer 120, or the channel part 130n may have substantially the same length as the seed layer 120 (L1 = L2).

According to one embodiment of the present disclosure, in a cross-section of the channel part 130n, a ratio of a sum of areas of crystals having a crystal grain size of 1 nm or more may be 50% or more to the entire cross-section area. In detail, based on a transmission electron microscope TEM image of the cross-section of the channel part 130n, the ratio of a sum of areas of crystals having a crystal grain size of 1 nm or more may be 50% or more to the entire cross-section area.

According to one embodiment of the present disclosure, the channel part 130n may include at least one crystal structure among, for example, a cubic crystal structure, a Bixbyite crystal structure, a Cubic Bixbyite crystal structure, a Spinel crystal structure, a Hexagonal crystal structure, and a Wurtzite crystal structure.

According to one embodiment of the present disclosure, the channel part 130n may have a crystal plane. The crystal plane of the channel part 130n may include, for example, at least one of a (400) crystal plane, a (222) crystal plane, a (220) crystal plane, a (311) crystal plane, and a (001) crystal plane. The crystal plane may be identified or measured from X-ray diffraction analysis XRD to the channel part 130n of the active layer 130.

The channel part 130n having a crystalline structure may have excellent physical and chemical stability. As a result, damage to the channel part 130n or deformation of the physical property of the channel part 130n may be suppressed or prevented during the manufacturing process or in the use of the thin film transistor 100. In addition, since the channel part 130n has a crystalline structure, it may have excellent resistance to hydrogen. As a result, the channel part 130n may have excellent stability. According to one embodiment of the present disclosure, since the channel part 130n has excellent stability, the thin film transistor 100 may have excellent operating stability.

The first connection part 130a and the second connection part 130b, which are not crystallized and exist in an amorphous state, may have excellent electrical conductivity. According to one embodiment of the present disclosure, the first connection part 130a and the second connection part 130b may each have a carrier concentration of 1.0 x 10¹⁹ea/cm³ or more. In detail, the first connection part 130a and the second connection part 130b may each have a carrier concentration of 1.0 x 10²¹ea/cm³ or more.

In addition, the first connection part 130a and the second connection part 130b may each have a sheet resistance of 10³ Ω/sq or less. In detail, the first connection part 130a and the second connection part 130b may each have a sheet resistance of 10² Ω/sq or less.

The first connection part 130a and the second connection part 130b having high carrier concentration and low surface resistance may have electrical characteristic similar to those of a conductor without a separate conductorization process. The term "conductorization" may refer to making something a conductor, e. g., by applying and/or coating an additional conductive layer to an otherwise non-conducting surface. Accordingly, the thickness of the first connection part 130a and the second connection part 130b may be reduced.

According to one embodiment of the present disclosure, the first connection part 130a and the second connection part 130b may be formed without performing a conductorization process to the active layer 130. As a result, expansion of the conductive region into the channel part 130n during the conductorization process may be prevented.

Referring to FIGs. 2 and 3, a gate insulating layer 140 is disposed on an active layer 130. The gate insulating layer 140 may include at least one of silicon oxide, silicon nitride, and metal oxide. The gate insulating layer 140 may have a single layer structure or a multilayer structure. The gate insulating layer 140 protects the channel part 130n.

Referring to FIG. 2, the gate insulating layer 140 may be formed over the entire upper portion of the substrate 110. For example, the gate insulating layer 140 may cover all of the channel part 130n, the first connection part 130a, and the second connection part 130b except for the contact region.

However, one embodiment of the present disclosure is not limited thereto, and the gate insulating layer 140 may be patterned. For example, the gate insulating layer 140 may be patterned into a shape corresponding to the gate electrode 150.

The gate electrode 150 is disposed on the gate insulating layer 140.

The gate electrode 150 may include at least one of an aluminum based metal such as aluminum (Al) or an aluminum alloy, a silver based metal such as silver (Ag) or a silver alloy, a copper based metal such as copper (Cu) or a copper alloy, a molybdenum based metal such as molybdenum (Mo) or a molybdenum alloy, chromium (Cr), tantalum (Ta), neodymium (Nd), and titanium (Ti). The gate electrode 150 may also have a multilayer structure including at least two conductive layers having different physical property.

The gate electrode 150 overlaps with the channel part 130n of the active layer 130. In addition, the seed layer 120 overlaps with the gate electrode 150.

Referring to FIGs. 1 and 2, the seed layer 120 may be disposed within the region of the gate electrode 150 in a region where the active layer 130 and the gate electrode 150 overlap in a plan view. In detail, the seed layer 120 may be disposed within the region defined by the gate electrode 150 in a region where the active layer 130 and the gate electrode 150 overlap in a plan view.

According to one embodiment of the present disclosure, the active layer 130 is disposed between the seed layer 120 and the gate electrode 150. In addition, the channel part 130n is disposed between the seed layer 120 and the gate electrode 150.

The channel part 130n of the active layer 130 has semiconductor characteristic and may have electrical conductivity when voltage is applied to the gate electrode 150. In order to drive the thin film transistor 100, the channel part 130n is positioned within an area to which an electric field generated by the gate electrode 150 is applied.

Referring to FIG. 1, the seed layer 120 is disposed within an area defined by the gate electrode 150 in a plan view. Accordingly, the channel part 130n, which is a crystallized portion 130c of the active layer 130, may be disposed within the area of the gate electrode 150.

If the seed layer 120 extends to the outside of the area defined by the gate electrode 150, the crystallized portion 130c of the active layer 130 may be formed outside the area defined by the gate electrode 150. In this case, even though voltage is applied to the gate electrode 150, the crystallized portion 130c disposed outside the area defined by the gate electrode 150 may not have sufficient mobility. As a result, the thin film transistor 100 may not be properly driven.

Therefore, as shown in FIG. 2, in the region overlapping with the active layer 130, the length L1 of the seed layer 120 may be designed to be smaller than the length of the gate electrode L3.

Also, referring to FIG. 1, in the region overlapping with the gate electrode 150, the width of the seed layer w1 may be designed to be larger than the width of the active layer w2. Here, the width is measured along a direction (dr2) perpendicular to a line connecting the first connection part 130a and the second connection part 130b.

If a part of the active layer 130 does not overlap the seed layer 120 in the width direction dr2, an electric short may occur.

In detail, a portion of the active layer 130 that does not overlap (e.g., non-overlapping) with the seed layer 120 will not be crystallized and will have a high carrier concentration and low electrical resistance. When a portion of the active layer 130, which does not overlap with the seed layer 120 in the width direction dr2, extends from the first connection part 130a to the second connection part 130b to form a connection region along the direction dr1, current flows through this connection region. As a result, an electric short or a leakage current occurs between the first connection part 130a and the second connection part 130b, and the thin film transistor 100 may not perform a switching function.

According to one embodiment of the present disclosure, the active layer 130 may be disposed within an area defined by the seed layer 120 in an area overlapping the seed layer 120 based on the plan view.

Referring to FIG. 2, an interlayer insulating film 170 is disposed on a gate insulating layer 140 and a gate electrode 150. The interlayer insulating film 170 is an insulating layer made of an insulating material. The interlayer insulating film 170 may be made of an organic material, an inorganic material, or a laminate of an organic material layer and an inorganic material layer. A source electrode 161 and a drain electrode 162 may be disposed on the interlayer insulating film 170.

The source electrode 161 and the drain electrode 162 may each include at least one of molybdenum (Mo), aluminum (Al), chromium (Cr), gold (Au), titanium (Ti), nickel (Ni), neodymium (Nd), copper (Cu), and alloys thereof. The source electrode 161 and the drain electrode 162 may each be formed of a single layer made of a metal or an alloy of metals, or may be formed of a multilayer of two or more layers.

According to one embodiment of the present disclosure, the source electrode 161 may be connected to the first connection part 130a. The source electrode 161 may be electrically connected to the first connection part 130a of the active layer 130 through a contact hole.

The drain electrode 162 may be spaced apart from the source electrode 161 and connected to the second connection part 130b. The drain electrode 162 may be electrically connected to the second connection part 130b of the active layer 130 through a contact hole.

According to one embodiment of the present disclosure, the first connection part 130a of the active layer 130 may be a source region, and the second connection part 130b may be a drain region. According to one embodiment of the present disclosure, the first connection part 130a may serve as a source electrode, and the second connection part 130b may serve as a drain electrode. The first connection part 130a and the second connection part 130b may be exchanged with each other.

FIG. 4 is a cross-sectional view of a thin film transistor 200 according to another embodiment of the present disclosure.

According to one embodiment of the present disclosure, the gate insulating layer 140 may be patterned. Referring to FIG. 4, the gate insulating layer 140 may be patterned into a shape corresponding to the gate electrode 150.

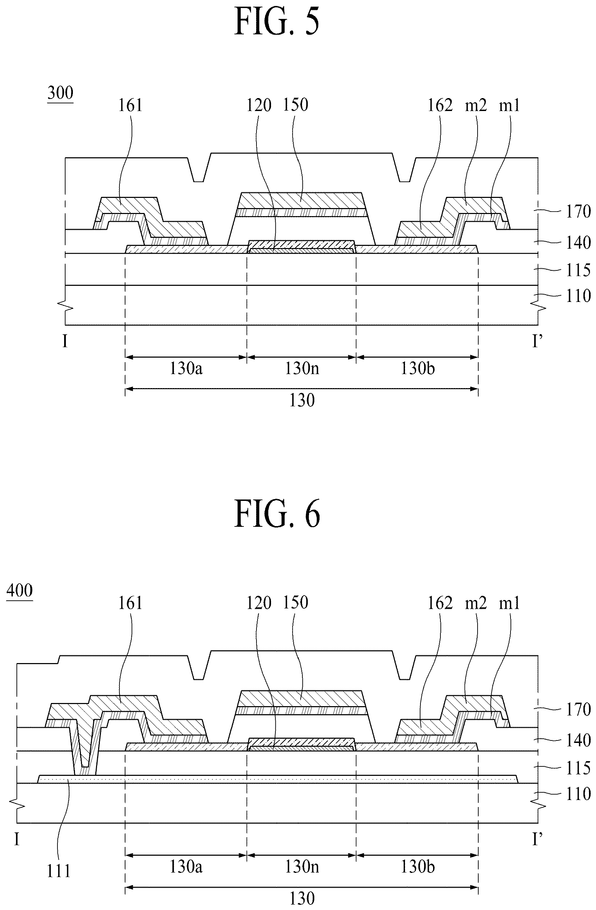

FIG. 5 is a cross-sectional view of a thin film transistor 300 according to another embodiment of the present disclosure.

Referring to FIG. 5, the source electrode 161 and the drain electrode 162 may be disposed on the same layer as the gate electrode 150. In detail, the source electrode 161 and the drain electrode 162 may be disposed on the gate insulating layer 140. In this case, the source electrode 161 and the drain electrode 162 may be made of the same material as the gate electrode 150 through the same process.

Referring to FIG. 5, after forming a contact hole in the gate insulating layer 140, a gate electrode 150, a source electrode 161, and a drain electrode 162 are formed, so that the source electrode 161 and the drain electrode 162 can each contact the active layer 130.

The gate electrode 150, the source electrode 161, and the drain electrode 162 may each include a first layer m1 and a second layer m2 on the first layer m1. The first layer m1 and the second layer m2 are made of different materials. According to one embodiment of the present disclosure, the first layer m1 may include at least one of molybdenum (Mo), titanium (Ti), chromium (Cr), nickel Ni, and neodymium (Nd). The second layer m1 may include at least one of copper (Cu), aluminum (Al), and gold (Au).

FIG. 6 is a cross-sectional view of a thin film transistor 400 according to another embodiment of the present disclosure.

Referring to FIG. 6, the source electrode 161 may be connected to the light shielding layer 111. In detail, the source electrode 161 may contact the light shielding layer 111 through a contact hole formed by penetrating the gate insulating layer 140 and the buffer layer 115.

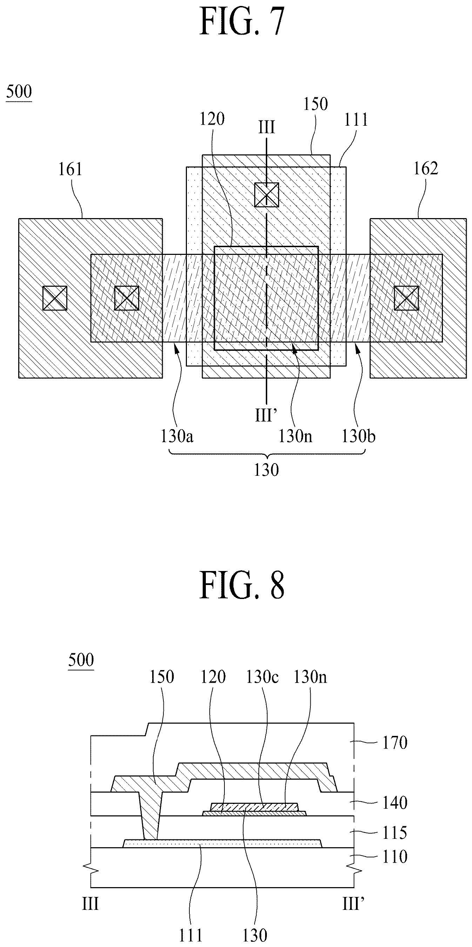

FIG. 7 is a plan view of a thin film transistor 500 according to another embodiment of the present disclosure, and FIG. 8 is a cross-sectional view taken along line III-III' of FIG. 7 according to one embodiment.

Referring to FIG. 7 and FIG.8, the gate electrode 150 may be connected to the light shielding layer 111. In detail, the gate electrode 150 may contact the light shielding layer 111 through a contact hole formed by penetrating the gate insulating layer 140 and the buffer layer 115.

When the gate electrode 150 and the light shielding layer 111 are connected to each other, the light shielding layer 111 may act as a lower gate electrode. As a result, the thin film transistor 500 may have an effect of having a double gate structure. The thin film transistor 500 of FIG. 7 and FIG. 8 may be referred to as a thin film transistor with double gate structure.

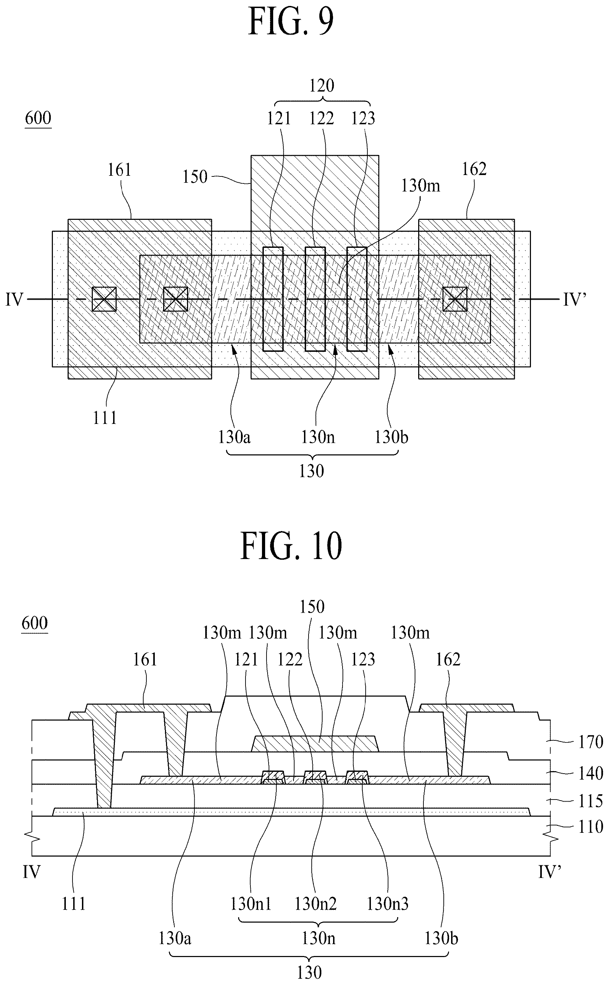

FIG. 9 is a plan view of a thin film transistor 600 according to another embodiment of the present disclosure, and FIG. 10 is a cross-sectional view taken along line IV-IV' of FIG. 9 according to one embodiment.

According to another embodiment of the present disclosure, the seed layer 120 may include a first pattern 121 and a second pattern 122 spaced apart from each other. Thus, the seed layer 120 has a plurality of patterns that are spaced apart from each other.

The first pattern 121 and the second pattern 122 of the seed layer 120 overlap with the gate electrode 150. In addition, each of the first pattern 121 and the second pattern 122 contacts the active layer 130.

The portion of the active layer 130 that overlaps the first pattern 121 and the second pattern 122 may be crystallized and may become a channel part 130n. A portion of the active layer 130 that overlaps the first pattern 121 may become a first channel 130n1, and a portion of the active layer 130 that overlaps the second pattern 122 may become a second channel 130n2.

Referring to FIG. 9 and FIG. 10, the channel part 130n may include a first channel 130n1 contacting the first pattern 121 and a second channel 130n2 contacting the second pattern 122.

Referring to FIG. 9 and FIG. 10, the seed layer 120 may further include a third pattern 123. A portion of the active layer 130 that overlaps with the third pattern 123 may become a third channel 130n3. In this case, the channel part 130n may include a first channel 130n1, a second channel 130n2, and a third channel 130n3.

Referring to FIG. 10, an amorphous portion 130m may exist between the first pattern 121 and the second pattern 122 and between the second pattern 122 and the third pattern 123.

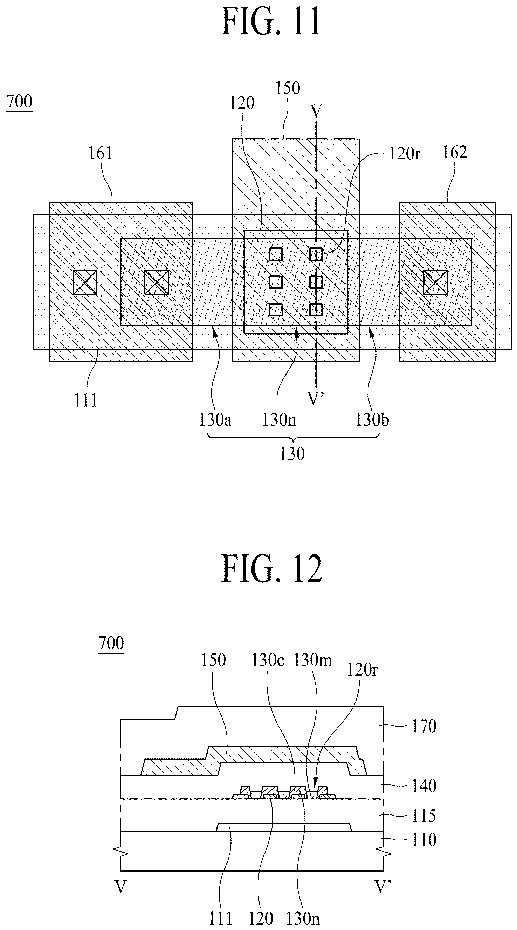

FIG. 11 is a plan view of a thin film transistor 700 according to another embodiment of the present disclosure, and FIG. 12 is a cross-sectional view taken along line V-V' of FIG. 11 according to one embodiment.

Referring to FIG. 11 and FIG. 12, the seed layer 120 may have one or more via holes 120r. The via holes 120r may overlap with the gate electrode 150.

The portion of the active layer 130 disposed in the via hole 120r may not be crystallized. In detail, an amorphous portion 130m of the active layer 130 may be disposed in the via hole 120r formed in the seed layer 120. Excluding the via hole 120r, the active layer 130 disposed on the seed layer 120 may be crystallized. A crystallized portion 130c of the active layer 130 may be disposed on the seed layer 120 excluding the via hole 120r.

The channel part 130n may be divided by the via hole 120r. By the via hole 120r, an effect such as a plurality of channels separated from each other being connected in series or in parallel may appear.

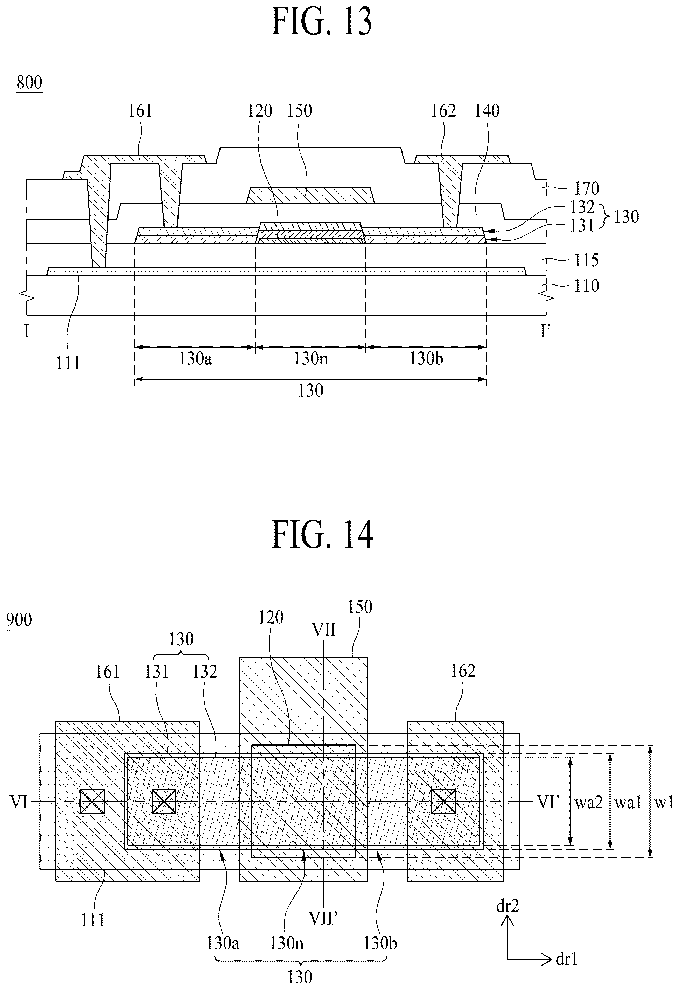

FIG. 13 is a cross-sectional view of a thin film transistor 800 according to another embodiment of the present disclosure.

In the thin film transistor 800 of FIG. 13, the active layer 130 has a multilayer structure.

Referring to FIG. 13, the active layer 130 includes a first oxide semiconductor layer 131 and a second oxide semiconductor layer 132 on the first oxide semiconductor layer 131. The first oxide semiconductor layer 131 and the second oxide semiconductor layer 132 may include a same semiconductor material or may include different semiconductor materials.

A portion of the first oxide semiconductor layer 131 that overlaps with the seed layer 120 and a portion of the second oxide semiconductor layer 132 that overlaps with the seed layer 120 are each crystallized to serve as a channel part 130n.

The first oxide semiconductor layer 131 supports the second oxide semiconductor layer 132. Therefore, the first oxide semiconductor layer 131 may be called a support layer. The main channel part may be formed in the second oxide semiconductor layer 132. However, one embodiment of the present disclosure is not limited thereto, and the main channel part may be formed in the first oxide semiconductor layer 131.

Referring to FIG. 13, the first oxide semiconductor layer 131 and the second oxide semiconductor layer 132 may be disposed between the seed layer 120 and the gate electrode 150.

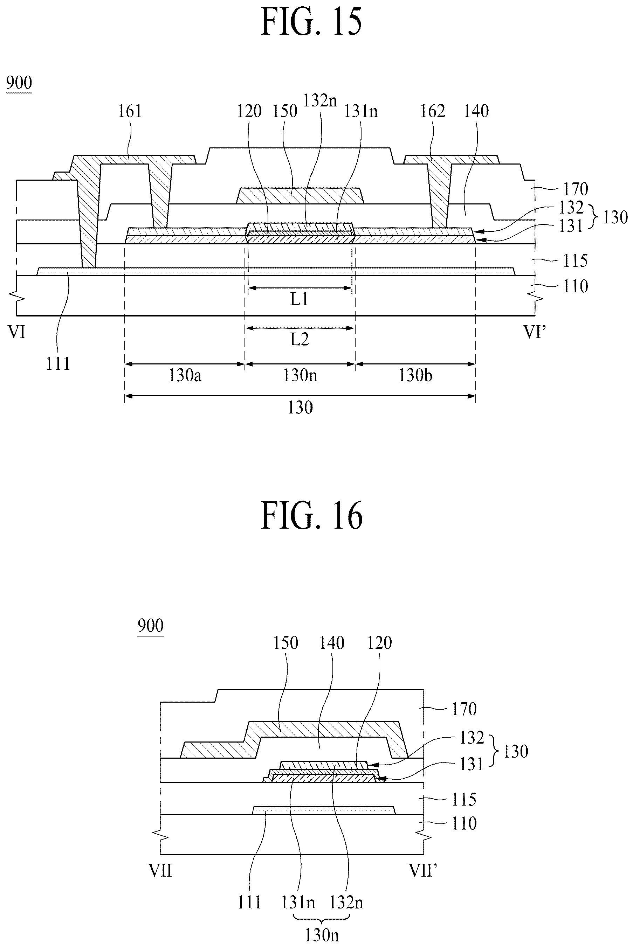

FIG. 14 is a plan view of a thin film transistor 900 according to another embodiment of the present disclosure, FIG. 15 is a cross-sectional view taken along line VI-VI' of FIG. 14 according to one embodiment, and FIG. 16 is a cross-sectional view taken along line VII-VII' of FIG. 14 according to one embodiment.

According to another embodiment of the present disclosure, the active layer 130 may include a first oxide semiconductor layer 131 and a second oxide semiconductor layer 132 on the first oxide semiconductor layer 131. Additionally, a seed layer 120 may be disposed between the first oxide semiconductor layer 131 and the second oxide semiconductor layer 132.

A portion of the first oxide semiconductor layer 131 that overlaps with the seed layer 120 and is in contact with the seed layer 120 may be crystallized to form a first channel part 131n. A portion of the second oxide semiconductor layer 132 that overlaps with the seed layer 120 and is in contact with the seed layer 120 may be crystallized to form a second channel part 132n. As a result, channel parts may be formed on the lower side and upper side of the seed layer 120.

Referring to FIG. 14 and FIG. 16, in the region overlapping with the gate electrode 150, the width of the seed layer w1 may be designed to be larger than the width of the first oxide semiconductor layer wa1 and the width of the second oxide semiconductor layer wa2.

Referring to FIG. 16, the seed layer 120 may cover the side surface of the first oxide semiconductor layer 131 in the width direction.

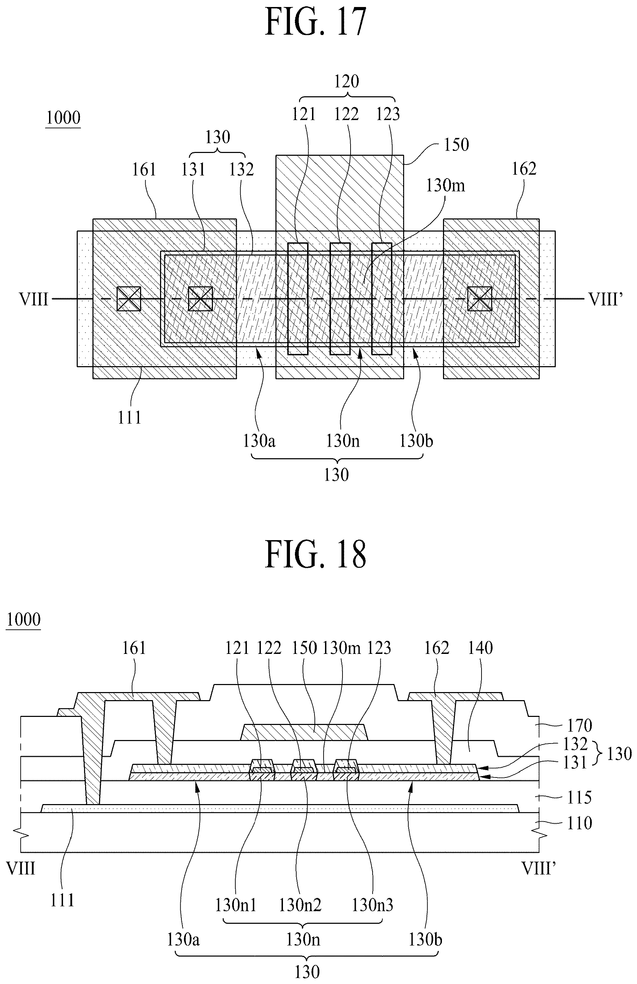

FIG. 17 is a plan view of a thin film transistor 1000 according to another embodiment of the present disclosure, and FIG. 18 is a cross-sectional view taken along line VIII-VIII' of FIG. 17 according to one embodiment.

Referring to FIG. 17 and FIG. 18, the active layer 130 includes a first oxide semiconductor layer 131 and a second oxide semiconductor layer 132, and the seed layer 120 may be disposed between the first oxide semiconductor layer 131 and the second oxide semiconductor layer 132.

The seed layer 120 may include a plurality of patterns including a first pattern 121, a second pattern 122, and a third pattern 123 that are spaced apart from each other.

The first pattern 121, the second pattern 122, and the third pattern 123 overlap with the gate electrode 150. In addition, the first pattern 121, the second pattern 122, and the third pattern 123 are each in contact with the active layer 130.

Portions of the active layer 130 that overlaps the first pattern 121, the second pattern 122, and the third pattern 123 may be crystallized to form a channel part 130n.

A portion of the first oxide semiconductor layer 131 and a portion of the second oxide semiconductor layer 132 overlapping the first pattern 121 each may be crystallized to form a first channel 130n1.

A portion of the first oxide semiconductor layer 131 and a portion of the second oxide semiconductor layer 132 overlapping the second pattern 122 each may be crystallized to form a second channel 130n2.

A portion of the first oxide semiconductor layer 131 and a portion of the second oxide semiconductor layer 132 overlapping the third pattern 123 each may be crystallized to form a third channel 130n3.

Referring to FIG. 17 and FIG. 18, the channel part 130n may include a first channel 130n1, a second channel 130n2, and a third channel 130n3.

Referring to FIG. 17 and FIG. 18, an amorphous portion 130m of the active layer 130 may be located between the first pattern 121 and the second pattern 122 and between the second pattern 122 and the third pattern 123.

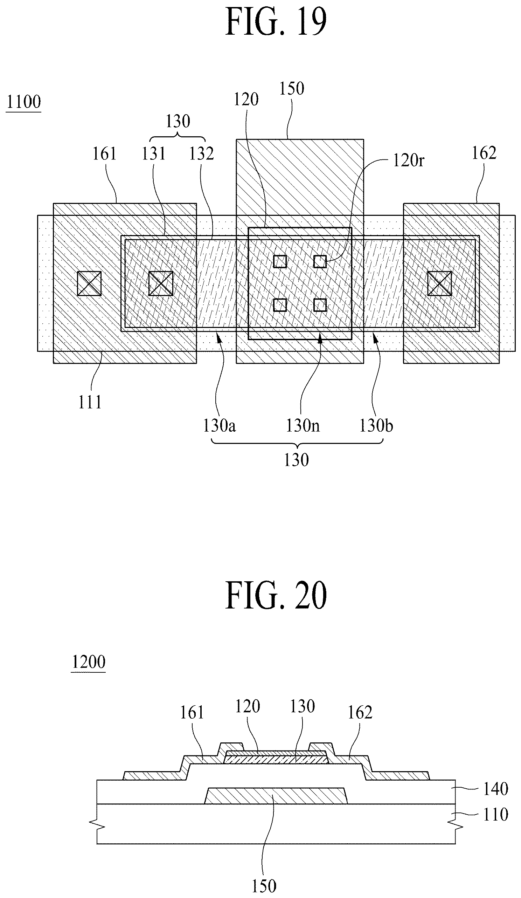

FIG. 19 is a plan view of a thin film transistor 1100 according to another embodiment of the present disclosure.

According to another embodiment of the present disclosure, the active layer 130 includes a first oxide semiconductor layer 131 and a second oxide semiconductor layer 132, and the seed layer 120 may be disposed between the first oxide semiconductor layer 131 and the second oxide semiconductor layer 132. The seed layer 120 may have one or more via holes 120r. The via holes 120r may overlap the gate electrode 150.

Referring to FIG. 19, the first oxide semiconductor layer 131 and the second oxide semiconductor layer 132 may contact each other in the via hole 120r.

FIG. 20 is a cross-sectional view of a thin film transistor 1200 according to another embodiment of the present disclosure.

Referring to FIG. 20, a thin film transistor 1200 according to another embodiment of the present disclosure includes a gate electrode 150 on a substrate 110, a gate insulating layer 140 on the gate electrode 150, an active layer 130 on the gate insulating layer 140, and a seed layer 120 on the active layer 130. In addition, a thin film transistor 1200 according to another embodiment of the present disclosure may include a source electrode 161 and a drain electrode 162 disposed on the gate insulating layer 140. The source electrode 161 and the drain electrode 162 are spaced apart from each other and each contacts the active layer 130.

Referring to FIG. 20, the active layer 130 may be disposed between the gate electrode 150 and the seed layer 120. The entire area of the active layer 130 may overlap the seed layer 120 in a plan view, and the entire active layer 130 may be crystallized.

The source electrode 161 and the drain electrode 162 each may contact the seed layer 120.

As shown in FIG. 20, a thin film transistor in which the gate electrode 150 is disposed below the active layer 130 is referred to as a thin film transistor having a bottom gate structure. On the other hand, a thin film transistor in which the gate electrode 150 is disposed above the active layer 130 as shown in FIGs. 1 to 19 is referred to as a thin film transistor having a top gate structure.

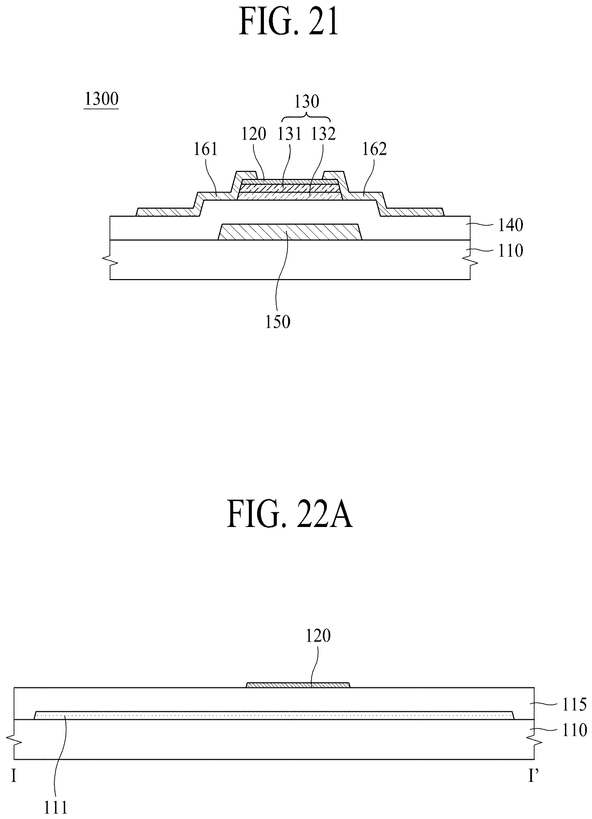

FIG. 21 is a cross-sectional view of a thin film transistor 1300 according to another embodiment of the present disclosure.

Referring to FIG. 21, the active layer 130 includes a first oxide semiconductor layer 131 and a second oxide semiconductor layer 132 on the first oxide semiconductor layer 131. The first oxide semiconductor layer 131 and the second oxide semiconductor layer 132 may include a same semiconductor material or may include different semiconductor materials.

The first oxide semiconductor layer 131 and the second oxide semiconductor layer 132 are crystallized by the seed layer 120 and serve as a channel part.

Referring to FIG. 21, the first oxide semiconductor layer 131 and the second oxide semiconductor layer 132 may be disposed between the seed layer 120 and the gate electrode 150. However, another embodiment of the present disclosure is not limited thereto, and the seed layer 120 may be disposed between the first oxide semiconductor layer 131 and the second oxide semiconductor layer 132. In addition, the seed layer 120 may be divided into a plurality of patterns, and the seed layer 120 may have one or more via holes.

Hereinafter, a manufacturing method for a thin film transistor 100 according to one embodiment of the present disclosure will be described.

The method for manufacturing a thin film transistor 100 according to one embodiment of the present disclosure includes forming a seed layer 120 on a substrate 100, forming an active layer 130 overlapping the seed layer 120, crystallizing a portion of the active layer that overlaps the seed layer 120 by heat treating the active layer 130, and forming a gate electrode 150 on the active layer 130.

FIGs. 22A to 22E are cross-sectional views illustrating a manufacturing method of a thin film transistor 100 according to one embodiment of the present disclosure.

Referring to FIG. 22A, a light shielding layer 111 is formed on a substrate 110, a buffer layer 115 is formed on the light shielding layer 111, and a seed layer 120 is formed on the buffer layer 115.

The seed layer 120 may have a thickness of 1 nm to 10 nm.

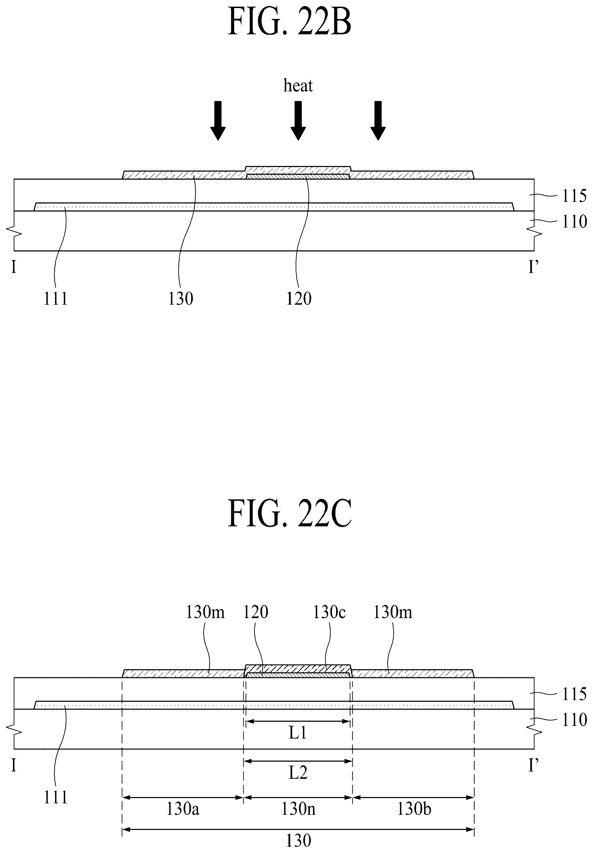

Referring to FIG. 22B, an active layer 130 may be formed on a seed layer 120. The active layer 130 may overlap the seed layer 120. A portion of the active layer 130 may contact the seed layer 120.

The active layer 130 may be made of an amorphous oxide semiconductor material. The amorphous oxide semiconductor material may have a high carrier concentration and an electrical conductivity similar to that of a metal or conductor.

Next, the active layer 130 is heat treated. As the active layer 130 is heat-treated, the portion of the active layer 130 that overlaps the seed layer 120 is crystallized.

The heat treatment temperature may be 300°C to 500°C. The heat treatment temperature may vary depending on the thickness of the seed layer 120.

For example, when the thickness of the seed layer 120 is 1 nm to 4 nm, the heat treatment may be performed at a temperature of 300° C. to 400° C. When the thickness of the seed layer 120 is 4 nm to 6 nm, the heat treatment may be performed at a temperature of 350° C. to 450° C. When the thickness of the seed layer 120 is 6 nm to 10 nm, the heat treatment may be performed at a temperature of 400° C. to 500° C.

According to one embodiment of the present disclosure, when the thickness of the seed layer 120 is "x" nm and the heat treatment temperature is "Y"°C, the heat treatment may be performed under conditions satisfying the following equation 1. [Equation 1] $Y = 22 , 2 x + 277,8$

Referring to FIG. 22C, an active layer 130 including a crystalline portion 130c and an amorphous portion 130m is formed by heat treatment. In detail, in the forming the active layer 130 before heat treatment, the active layer 130 has an amorphous structure. A portion of the active layer 130 that overlaps the seed layer 120 is transformed into a crystalline structure by heat treatment.

The crystalline portion 130c of the active layer 130 becomes the channel part 130n. The amorphous portion 130m of the active layer 130 becomes the first connection part 130a and the second connection part 130b.

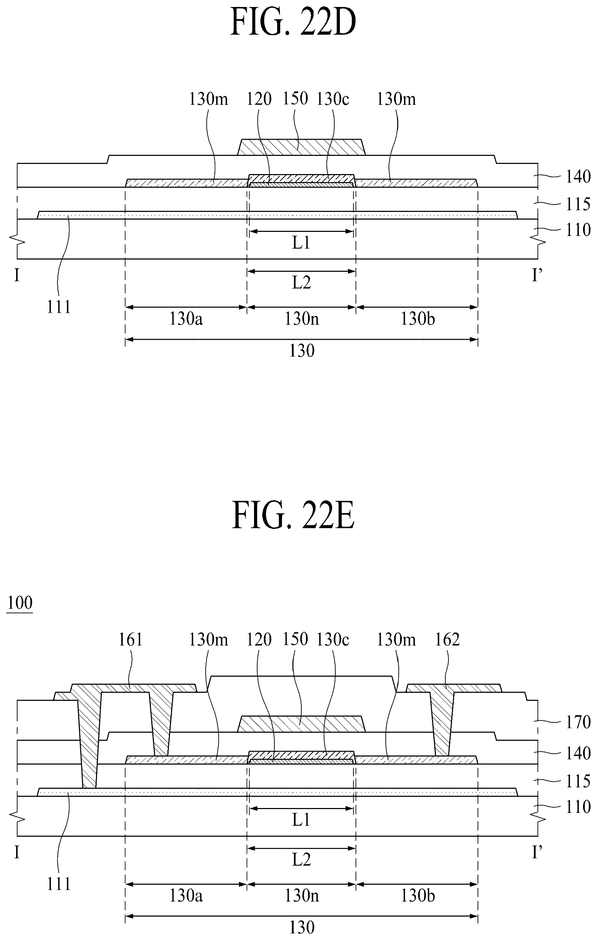

Referring to FIG. 22D, a gate insulating layer 140 is formed on an active layer 130, and a gate electrode 150 is formed on the gate insulating layer 140. The gate electrode 150 overlaps at least partially with the active layer 130. In detail, the gate electrode 150 is formed to overlap with the channel part 130n.

Referring to FIG. 22E, an interlayer insulating film 170 is formed on a gate electrode 150, and a source electrode 161 and a drain electrode 162 are formed on the interlayer insulating film 170. According to another embodiment of the present disclosure, in the forming the gate electrode 150, the source electrode 161 and the drain electrode 162 may be formed together with the gate electrode 150.

Hereinafter, a display apparatus including at least one of the thin film transistors described above will be described in detail.

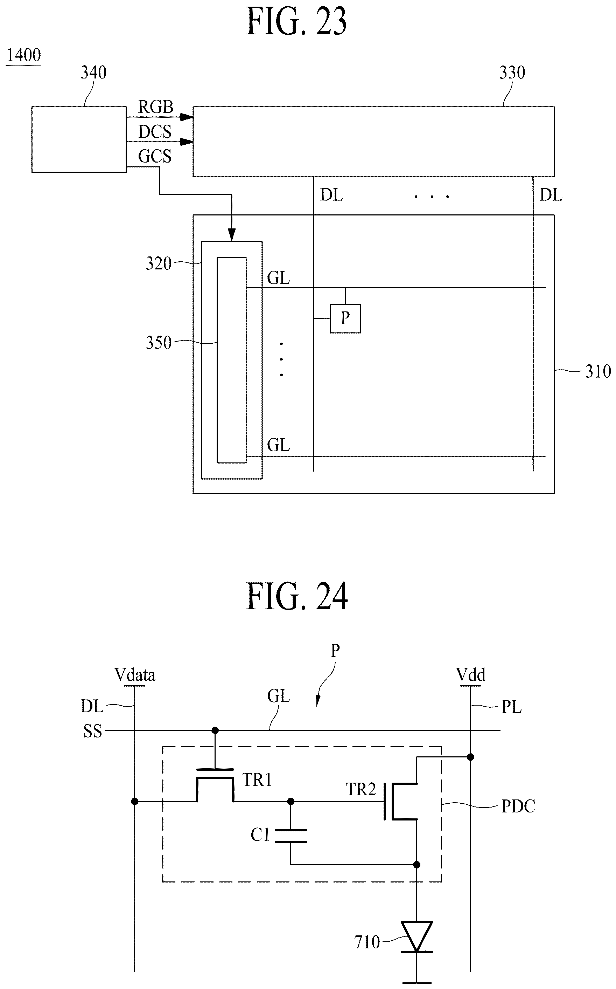

FIG. 23 is a schematic diagram of a display apparatus 1400 according to another embodiment of the present disclosure.

The display apparatus 1400 according to another embodiment of the present disclosure may include a display panel 310, a gate driver 320, a data driver 330, and a control unit 340.

The gate lines GL and data lines DL are disposed on the display panel 310, and pixels P are arranged in the intersection area of the gate lines GL and data lines DL. An image is displayed by driving the pixels P.

The control unit 340 (e.g., a circuit) controls the gate driver 320 and the data driver 330.

The control unit 340 outputs a gate control signal GCS for controlling the gate driver 320 and a data control signal DCS for controlling the data driver 330 using a signal supplied from an external system. In addition, the control unit 340 samples input image data input from an external system, rearranges it, and supplies the rearranged image data RGB to the data driver 330.

The gate control signal GCS may include a gate start pulse GSP, a gate shift clock GSC, a gate output enable signal GOE, a start signal Vst, a gate clock GCLK, etc. In addition, the gate control signal GCS may include control signals for controlling a shift register.

The data control signal DCS may include a source start pulse SSP, a source shift clock signal SSC, a source output enable signal SOE, a polarity control signal POL, etc.

The data driver 330 supplies data voltage to the data lines DL of the display panel 310. In detail, the data driver 330 can convert image data RGB input from the control unit 340 into analog data voltage and supply the data voltage to the data lines DL.

The gate driver 320 sequentially supplies gate pulses GP to the gate lines GL during one frame. Here, one frame refers to a period during which one image is output through the display panel. In addition, the gate driver 320 supplies a gate off signal Goff capable of turning off the switching element to the gate lines GL during the remaining period during which the gate pulse GP is not supplied during one frame. Hereinafter, the gate pulse GP and the gate off signal Goff are collectively referred to as a scan signal SS.

According to one embodiment of the present disclosure, the gate driver 320 may be mounted on the substrate 110. As described above, a structure in which the gate driver 320 is directly mounted on the substrate 110 is referred to as a Gate In Panel GIP structure.

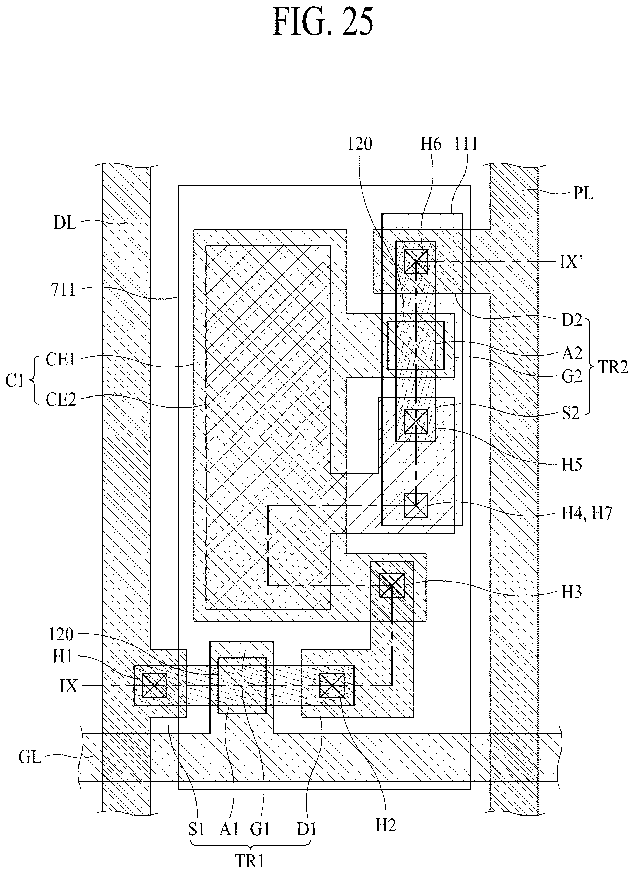

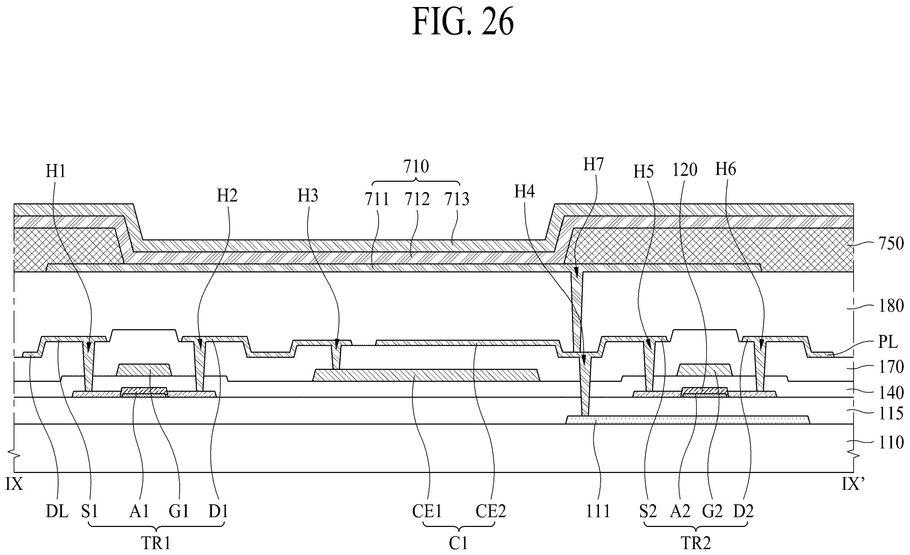

FIG. 24 is a circuit diagram for one pixel P of FIG. 23, FIG. 25 is a plan view for the pixel P of FIG. 24 according to one embodiment, and FIG. 26 is a cross-sectional view taken along IX-IX' of FIG. 25 according to one embodiment.

The circuit diagram of FIG. 24 is an equivalent circuit diagram for a pixel P of a display apparatus 1400 including an organic light emitting diode OLED as a display element 710.

The pixel P includes a display element 710 and a pixel driver PDC that drives the display element 710.

The first thin film transistor TR1 is connected to the gate line GL and the data line DL, and is turned on or off by the scan signal SS supplied through the gate line GL.

The data line DL provides a data voltage Vdata to the pixel driver PDC, and the first thin film transistor TR1 controls the application of the data voltage Vdata.

The driving power line PL provides a driving voltage Vdd to the display element 710, and the second thin film transistor TR2 controls the driving voltage Vdd. The driving voltage Vdd is a pixel driving voltage for driving the organic light emitting diode OLED, which is the display element 710.

When the first thin film transistor TR1 is turned on by a scan signal SS applied through the gate line GL from the gate driver 320, the data voltage Vdata supplied through the data line DL is supplied to the gate electrode of the second thin film transistor TR2 connected to the display element 710. The data voltage Vdata is charged in the first capacitor C1 formed between the gate electrode and the source electrode of the second thin film transistor TR2. The first capacitor C1 is a storage capacitor Cst.

The amount of current supplied to the organic light emitting diode OLED, which is a display element 710, through the second thin film transistor TR2 is controlled according to the data voltage Vdata, and accordingly, the gradation of light output from the display element 710 may be controlled.

Referring to FIG. 25 and FIG. 26, a first thin film transistor TR1 and a second thin film transistor TR2 are disposed on a substrate 110.

The substrate 110 may be made of glass or plastic. As the substrate 110, a plastic having flexible property, for example, polyimide PI, may be used.

A light shielding layer 111 is disposed on a substrate 110. The light shielding layer 111 may have light blocking property. The light shielding layer 111 may block light incident from the outside to protect the active layer A2.

A buffer layer 115 is disposed on the light shielding layer 111. The buffer layer 115 is made of an insulating material and protects the active layers A1, A2 from moisture or oxygen flowing in from the outside. A part of the light shielding layer 111 may become a capacitor electrode.

A seed layer 120 is disposed on the buffer layer 115. The seed layer 120 may be disposed in an area corresponding to the channel part of the first thin film transistor TR1 and an area corresponding to the channel part of the second thin film transistor TR2, respectively.

An active layer A1 of a first thin film transistor TR1 and an active layer A2 of a second thin film transistor TR2 are disposed on a seed layer 120.

The active layers A1, A2 may include, for example, an oxide semiconductor material. The active layers A1, A2 may be formed of an oxide semiconductor layer made of an oxide semiconductor material. The active layers A1, A2 may include a crystalline portion and an amorphous portion. The channel part of the active layers A1, A2 has a crystalline structure. A portion of the active layers A1, A2 that overlaps with the seed layer 120 may be crystallized and have a crystalline structure.

A gate insulating layer 140 is disposed on the active layers A1, A2. The gate insulating layer 140 has insulating property and separates the active layers A1, A2 from the gate electrodes G1, G2. The gate insulating layer 140 can cover the entire upper surface of the active layers A1, A2.

A gate electrode G1 of a first thin film transistor TR1 and a gate electrode G2 of a second thin film transistor TR2 are disposed on a gate insulating layer 140.

The gate electrode G1 of the first thin film transistor TR1 overlaps at least partly with the active layer A1 of the first thin film transistor TR1. The gate electrode G2 of the second thin film transistor TR2 overlaps at least partly with the active layer A2 of the second thin film transistor TR2.

Referring to FIGs. 25 and 26, a first capacitor electrode CE1 may be disposed on the same layer as the gate electrodes G1, G2. According to one embodiment of the present disclosure, the gate electrode G2 of the second thin film transistor TR2 may extend on the gate insulating layer 140 to become the first capacitor electrode CE1.

An interlayer insulating film 170 is disposed on the gate electrodes G1, G2 and the first capacitor electrode CE1.

Source electrodes S1, S2 and drain electrodes D1, D2 are disposed on the interlayer insulating film 170. The source electrodes S1, S2 and drain electrodes D1, D2 are distinguished only for convenience of explanation, and the source electrodes S1, S2 and drain electrodes D1, D2 may be interchanged.

In addition, a data line DL and a driving power line PL are disposed on the interlayer insulating film 170. The source electrode S1 of the first thin film transistor TR1 may be formed integrally with the data line DL. The drain electrode D2 of the second thin film transistor TR2 may be formed integrally with the driving power line PL.

According to one embodiment of the present disclosure, the source electrode S1 and the drain electrode D1 of the first thin film transistor TR1 are spaced apart from each other and are respectively connected to the active layer A1 of the first thin film transistor TR1. The source electrode S2 and the drain electrode D2 of the second thin film transistor TR2 are spaced apart from each other and are respectively connected to the active layer A2 of the second thin film transistor TR2.

In detail, the source electrode S1 of the first thin film transistor TR1 is connected to the active layer A1 of the first thin film transistor TR1 through the first contact hole H1.

The drain electrode D1 of the first thin film transistor TR1 contacts the drain connection part of the active layer A1 through the second contact hole H2 and is connected to the first capacitor electrode CE1 through the third contact hole H3.

The source electrode S2 of the second thin film transistor TR2 extends over the interlayer insulating film 170, and a portion of it functions as a second capacitor electrode CE2. The first capacitor electrode CE1 and the second capacitor electrode CE2 overlap to form a first capacitor C1.

The source electrode S2 of the second thin film transistor TR2 contacts the light shielding layer 111 through the fourth contact hole H4 and contacts the active layer A2 through the fifth contact hole H5.

The drain electrode D2 of the second thin film transistor TR2 contacts the active layer A2 through the sixth contact hole H6.

The first thin film transistor TR1 functions as a switching transistor that controls the data voltage Vdata applied to the pixel driver PDC. The second thin film transistor TR2 functions as a driving transistor that controls the driving voltage Vdd applied to the display element 710.

planarization layer 180 is disposed on the source electrodes S1, S2, the drain electrodes D1, D2, the second capacitor electrode CE2, the data line DL, and the driving power line PL. The planarization layer 180 planarizes the upper portions of the first thin film transistor TR1 and the second thin film transistor TR2, and protects the first thin film transistor TR1 and the second thin film transistor TR2.

A first electrode 711 of a display element 710 is disposed on a planarization layer 180. The first electrode 711 of the display element 710 contacts a second capacitor electrode CE2 through a seventh contact hole H7 formed in the planarization layer 180. As a result, the first electrode 711 may be connected to a second source electrode S2 of a second thin film transistor TR2.

A bank layer 750 is arranged at the edge of the first electrode 711. The bank layer 750 defines a light emitting area of the display element 710.

An organic light emitting layer 712 is disposed on a first electrode 711, and a second electrode 713 is disposed on the organic light emitting layer 712. Accordingly, a display element 710 is completed. The display element 710 illustrated in FIG. 26 is an organic light emitting diode OLED. Therefore, a display apparatus 100 according to an embodiment of the present disclosure is an organic light emitting display apparatus.

A pixel driver PDC according to another embodiment of the present disclosure may be formed in various structures other than the structures described above. The pixel driver PDC may include, for example, three or more thin film transistors and two or more capacitors.

The thin film transistor according to one embodiment of the present disclosure includes a seed layer and an active layer contact the seed layer, and a portion of the active layer contact the seed layer may have a crystalline structure. The crystalline portion of the active layer may be a channel part. According to one embodiment of the present disclosure, the channel part may have a crystalline structure, and thus may have excellent resistance to hydrogen, and the channel part may have excellent stability. Therefore, the thin film transistor according to one embodiment of the present disclosure may have excellent electrical stability.

According to one embodiment of the present disclosure, a portion of the active layer that contacts the seed layer may have a crystalline structure and become a channel part, and a portion that does not contact the seed layer may have electrical characteristic similar to metal. Therefore, according to one embodiment of the present disclosure, a connection part that functions as a wiring portion may be formed without going through a conductorization process.

According to one embodiment of the present disclosure, since the active layer has both a crystalline portion and an amorphous portion, the thin film transistor may have excellent reliability and excellent electrical characteristic. A display apparatus according to one embodiment of the present disclosure including such a thin film transistor may have excellent display performance and excellent reliability.

According to one embodiment of the present disclosure may include an active layer, and a portion of the active layer that contacts the seed layer may have a crystalline structure.

In addition to the effects mentioned above, other features and advantages of the present disclosure are described below or may be clearly understood by those skilled in the art to which the present disclosure pertains from such description and explanation.

## Claims

1. A thin film transistor (100, 200, 300, 400, 500, 600, 700, 800, 900, 1000, 1100, 1200, 1300) comprising:
a seed layer (120) having an amorphous structure;
an active layer (130) overlapping the seed layer (120) and including a channel part (130n), wherein the channel part (130n) contacts the seed layer (120) and has a crystalline structure; and
a gate electrode (150) overlapping the seed layer (120) and at least a portion of the active layer (130) in a planar view of the thin film transistor (100, 200, 300, 400, 500, 600, 700, 800, 900, 1000, 1100, 1200, 1300),
**characterized in that** a length of the seed layer (120) is less than a length of the gate electrode (150) along a first direction (dr1).

2. The thin film transistor of claim 1, wherein the channel part (130n) is disposed between the seed layer (120) and the gate electrode (150).

3. The thin film transistor of claim 1 or 2, wherein the active layer (130) includes:
a first connection part (130a) connected to a first side of the channel part (130n); and
a second connection part (130b) connected to a second side of the channel part (130n) that is opposite the first side of the channel part (130n),
wherein the first connection part (130a) and the second connection part (130b) each have an amorphous structure that is different from the crystalline structure of the channel part (130n).

4. The thin film transistor of claim 3, wherein a width of the seed layer (120) is greater than a width of the active layer (130) along a second direction that is different from the first direction; and/or
wherein a carrier concentration of the seed layer (120) is less than a carrier concentration of the channel part (130n), a carrier concentration of the first connection part (130a), and a carrier concentration of the second connection part (130b), wherein the carrier concentration of the seed layer (120) preferably is 1.0 × 10¹⁶ cm⁻³ or less.

5. The thin film transistor of any of the preceding claims, wherein a thickness of the seed layer (120) is in a range of 1 nm to 10 nm;
wherein the amorphous structure of the seed layer (120) includes crystallites having a grain size of 1 nm or more, wherein a ratio of a sum of areas of the crystallites having the grain size of 1 nm or more is 10% or less is based on an entire cross-sectional area of the seed layer (120); and/or
wherein in the channel part (130n), a ratio of a sum of areas of crystallites having a grain size of 1 nm or more is 50% or more based on an entire cross-sectional area of the channel part (130n).

6. The thin film transistor of any of the preceding claims, wherein the seed layer (120) includes at least one of indium zinc oxide (InZnO) based oxide semiconductor material, indium gallium zinc oxide IGZO (InGaZnO) based oxide semiconductor material, indium gallium zinc tin oxide (InGaZnSnO) based oxide semiconductor material, gallium zinc tin oxide (GaZnSnO) based oxide semiconductor material, gallium zinc oxide (GaZnO) based oxide semiconductor material, and gallium oxide (GaO) based oxide semiconductor material.

7. The thin film transistor of any of the preceding claims, wherein the active layer (130) includes at least one of indium gallium zinc oxide (InGaZnO) based, indium gallium oxide (InGaO) based, indium gallium zinc tin oxide (InGaZnSnO) based, gallium zinc tin oxide (GaZnSnO) based, gallium zinc oxide (GaZnO) based, gallium oxide (GaO) based, tin oxide (SnO) based, indium tin oxide (InSnO) based, indium tin zinc oxide (InSnZnO) based, indium zinc oxide (InZnO) based, zinc oxide (ZnO) based, indium oxide (InO) based, zinc oxide (ZnO) based, and iron indium zinc oxide (FeInZnO) based oxide semiconductor materials, wherein the active layer (130) preferably further includes at least one of beryllium (Be), boron (B), carbon (C), aluminum (Al), silicon (Si), iron (Fe), calcium (Ca), tin (Sn), titanium (Ti), tantalum (Ta), vanadium (V), yttrium (Y), and zirconium (Zr).

8. The thin film transistor of any of the preceding claims, wherein the seed layer (120) and the active layer (130) include at least one same metal element.

9. The thin film transistor of any of the preceding claims, wherein the crystalline structure of the channel part includes at least one of a (400) crystal plane, a (222) crystal plane, a (220) crystal plane, a (311) crystal plane, or a (001) crystal plane.

10. The thin film transistor of any of the preceding claims, wherein the seed layer (120) includes a first pattern (121) and a second pattern (121) that are spaced apart from each other and overlap the gate electrode (150), wherein the active layer (130) is disposed between the first pattern (121) and the second pattern (122), wherein the active layer (130) is in contact with the first pattern (121) and the second pattern (122),
wherein the channel part (130n) preferably includes:
a first channel (130n1) contacting the first pattern (121); and
a second channel (130n2) contacting the second pattern (122).

11. The thin film transistor of any of the preceding claims, wherein the seed layer (120) has at least one via hole (120r) that overlaps the gate electrode (150), wherein a portion of the active layer (130) is disposed in the at least one via hole (120r); and/or
wherein the active layer (130) includes:
a first oxide semiconductor layer (131); and
a second oxide semiconductor layer (132) disposed on the first oxide semiconductor layer (131),
wherein the seed layer (120) is formed between the first oxide semiconductor layer (131) and second oxide semiconductor layer (132).

12. A display apparatus (1400) comprising:
the thin film transistor according to any of the preceding claims.

13. A manufacturing method of a thin film transistor (100, 200, 300, 400, 500, 600, 700, 800, 900, 1000, 1100, 1200, 1300) comprising:
forming a seed layer (120) on a substrate (110);
forming an active layer (130) overlapping the seed layer (120) such that a portion of the active layer (130) is in contact with the seed layer (120) and another portion of the active layer (130) is not in contact with the seed layer (120);
crystallizing the portion of the active layer (130) that contacts the seed layer (120) by heat treating the active layer (130); and
forming a gate electrode (150) on the active layer (130),
**characterized in that** a length of the seed layer (120) is less than a length of the gate electrode (150) along a first direction (dr1).

14. The manufacturing method of claim 13, wherein the active layer (130) has an amorphous structure in the forming of the active layer (130) and the portion of the active layer (130) contacting the seed layer (120) is transformed into a crystalline structure by the heat treating.

15. The manufacturing method of claim 13 or 14, wherein a thickness of the seed layer (120) is 1 nm to 10 nm and wherein a temperature of the heat treating is in a range of 300°C to 500°C, wherein performing the heat treating preferably satisfies an Equation 1: [Equation 1] $Y = 22.2 x + 277.8$ where "x" is the thickness of the seed layer (120) in nm and the temperature of the heat treating is "Y" in °C.

## Patentansprüche

1. Dünnschichttransistor (100, 200, 300, 400, 500, 600, 700, 800, 900, 1000, 1100, 1200, 1300), der umfasst:
eine Keimschicht (120), die eine amorphe Struktur aufweist;
eine aktive Schicht (130), die die Keimschicht (120) überlappt und einen Kanalabschnitt (130n) enthält, wobei der Kanalabschnitt (130n) die Keimschicht (120) berührt und eine kristalline Struktur aufweist; und
eine Gate-Elektrode (150), die in einer Draufsicht des Dünnschichttransistor (100, 200, 300, 400, 500, 600, 700, 800, 900, 1000, 1100, 1200, 1300) die Keimschicht (120) und wenigstens einen Abschnitt der aktiven Schicht (130) überlappt,
**dadurch gekennzeichnet, dass** eine Länge der Keimschicht (120) entlang einer ersten Richtung (dr1) kleiner als eine Länge der Gate-Elektrode (150) ist.

2. Dünnschichttransistor nach Anspruch 1, wobei der Kanalabschnitt (130n) zwischen der Keimschicht (120) und der Gate-Elektrode (150) angeordnet ist.

3. Dünnschichttransistor nach Anspruch 1 oder 2, wobei die aktive Schicht (130) enthält:
einen ersten Verbindungsabschnitt (130a), der mit einer ersten Seite des Kanalabschnitts (130n) verbunden ist; und
einen zweiten Verbindungsabschnitt (130b), der mit einer zweiten Seite des Kanalabschnitts (130n), die der ersten Seite des Kanalabschnitts (130n) gegenüberliegt, verbunden ist,
wobei der erste Verbindungsabschnitt (130a) und der zweite Verbindungsabschnitt (130b) jeweils eine amorphe Struktur aufweisen, die von der kristallinen Struktur des Kanalabschnitts (130n) verschieden ist.

4. Dünnschichttransistor nach Anspruch 3, wobei eine Breite der Keimschicht (120) entlang einer zweiten Richtung, die von der ersten Richtung verschieden ist, größer als eine Breite der aktiven Schicht (130) ist; und/oder
wobei eine Ladungsträgerkonzentration der Keimschicht (120) kleiner als eine Ladungsträgerkonzentration des Kanalabschnitts (130n), eine Ladungsträgerkonzentration des ersten Verbindungsabschnitts (130a) und eine Ladungsträgerkonzentration des zweiten Verbindungsabschnitts (130b) ist, wobei die Ladungsträgerkonzentration der Keimschicht (120) vorzugsweise 1,0 · 10¹⁶ cm⁻³ oder kleiner ist.

5. Dünnschichttransistor nach einem der vorhergehenden Ansprüche, wobei eine Dicke der Keimschicht (120) in einem Bereich von 1 nm bis 10 nm liegt;
wobei die amorphe Struktur der Keimschicht (120) Kristallite mit einer Korngröße von 1 nm oder mehr enthält, wobei ein Verhältnis einer Summe der Flächen der Kristallite mit der Korngröße von 1 nm oder mehr bezogen auf die Gesamtquerschnittsfläche der Keimschicht (120) 10 % oder weniger ist; und/oder
wobei ein Verhältnis der Summe der Flächen der Kristallite mit einer Korngröße von 1 nm oder mehr in dem Kanalabschnitt (130n) bezogen auf die Gesamtquerschnittsfläche des Kanalabschnitts (130n) 50 % oder mehr ist.

6. Dünnschichttransistor nach einem der vorhergehenden Ansprüche, wobei die Keimschicht (120) wenigstens eines von Oxidhalbleitermaterial basierend auf Indium-Zink-Oxid (InZnO), Oxidhalbleitermaterial basierend auf Indium-Gallium-Zink-Oxid IGZO (InGaZnO), Oxidhalbleitermaterial basierend auf Indium-Gallium-Zink-Zinn-Oxid (InGaZnSnO), Oxidhalbleitermaterial basierend auf Gallium-Zink-Zinn-Oxid (GaZnSnO), Oxidhalbleitermaterial basierend auf Gallium-Zink-Oxid (GaZnO) und Oxidhalbleitermaterial basierend auf Galliumoxid (GaO) enthält.

7. Dünnschichttransistor nach einem der vorhergehenden Ansprüche, wobei die aktive Schicht (130) wenigstens eines von Oxidhalbleitermaterial basierend auf Indium-Gallium-Zink-Oxid (InGaZnO), Oxidhalbleitermaterial basierend auf Indium-Gallium-Oxid (InGaO), Oxidhalbleitermaterial basierend auf Indium-Gallium-Zink-Zinn-Oxid (InGaZnSnO), Oxidhalbleitermaterial basierend auf Gallium-Zink-Zinn-Oxid (GaZnSnO), Oxidhalbleitermaterial basierend auf Gallium-Zink-Oxid (GaZnO), Oxidhalbleitermaterial basierend auf Galliumoxid (GaO), Oxidhalbleitermaterial basierend auf Zinnoxid (SnO), Oxidhalbleitermaterial basierend auf Indium-Zinn-Oxid (InSnO), Oxidhalbleitermaterial basierend auf Indium-Zinn-Zink-Oxid (InSnZnO), Oxidhalbleitermaterial basierend auf Indium-Zink-Oxid (InZnO), Oxidhalbleitermaterial basierend auf Zinkoxid (ZnO), Oxidhalbleitermaterial basierend auf Indiumoxid (InO), Oxidhalbleitermaterial basierend auf Zinkoxid (ZnO) und Oxidhalbleitermaterial basierend auf Eisen-Indium-Zink-Oxid (FeInZnO)-Oxid enthält, wobei die aktive Schicht (130) vorzugsweise ferner wenigstens eines von Beryllium (Be), Bor (B), Kohlenstoff (C), Aluminium (Al), Silicium (Si), Eisen (Fe), Calcium (Ca), Zinn (Sn), Titan (Ti), Tantal (Ta), Vanadium (V), Yttrium (Y) und Zirconium (Zr) enthält.

8. Dünnschichttransistor nach einem der vorhergehenden Ansprüche, wobei die Keimschicht (120) und die aktive Schicht (130) wenigstens ein gleiches Metallelement enthalten.

9. Dünnschichttransistor nach einem der vorhergehenden Ansprüche, wobei die kristalline Struktur des Kanalabschnitts wenigstens eines einer (400)-Kristallebene, einer (222)-Kristallebene, einer (220)-Kristallebene, einer (311)-Kristallebene oder einer (001)-Kristallebene enthält.

10. Dünnschichttransistor nach einem der vorhergehenden Ansprüche, wobei die Keimschicht (120) ein erstes Muster (121) und ein zweites Muster (121), die voneinander beabstandet sind und mit der Gate-Elektrode (150) überlappen, enthält, wobei die aktive Schicht (130) zwischen dem ersten Muster (121) und dem zweiten Muster (122) angeordnet ist, wobei die aktive Schicht (130) mit dem ersten Muster (121) und mit dem zweiten Muster (122) in Kontakt steht,
wobei der Kanalabschnitt (130n) vorzugsweise Folgendes enthält:
einen ersten Kanal (130n1), der das erste Muster (121) berührt; und
einen zweiten Kanal (130n2), der das zweite Muster (122) berührt.

11. Dünnschichttransistor nach einem der vorhergehenden Ansprüche, wobei die Keimschicht (120) wenigstens ein Kontaktloch (120r), das die Gate-Elektrode (150) überlappt, aufweist, wobei ein Abschnitt der aktiven Schicht (130) in dem wenigstens einen Kontaktloch (120r) angeordnet ist; und/oder
wobei die aktive Schicht (130) Folgendes enthält:
eine erste Oxidhalbleiterschicht (131); und
eine zweite Oxidhalbleiterschicht (132), die auf der ersten Oxidhalbleiterschicht (131) angeordnet ist,
wobei die Keimschicht (120) zwischen der ersten Oxidhalbleiterschicht (131) und der zweiten Oxidhalbleiterschicht (132) gebildet ist.

12. Anzeigevorrichtung (1400), die umfasst:
den Dünnschichttransistor nach einem der vorhergehenden Ansprüche.

13. Herstellungsverfahren für einen Dünnschichttransistor (100, 200, 300, 400, 500, 600, 700, 800, 900, 1000, 1100, 1200, 1300), wobei das Verfahren Folgendes umfasst:
Bilden einer Keimschicht (120) auf einem Substrat (110)
Bilden einer aktiven Schicht (130), die mit der Keimschicht (120) überlappt, in der Weise, dass ein Abschnitt der aktiven Schicht (130) mit der Keimschicht (120) in Kontakt ist und dass ein anderer Abschnitt der aktiven Schicht (130) mit der Keimschicht (120) nicht in Kontakt ist;
Kristallisieren des Abschnitts der aktiven Schicht (130), der mit der Keimschicht (120) in Kontakt ist, durch Wärmebehandlung der aktiven Schicht (130); und
Bilden einer Gate-Elektrode (150) auf der aktiven Schicht (130),
**dadurch gekennzeichnet, dass** eine Länge der Keimschicht (120) entlang einer ersten Richtung (dr1) kleiner als eine Länge der Gate-Elektrode (150) ist.

14. Herstellungsverfahren nach Anspruch 13, wobei die aktive Schicht (130) beim Bilden der aktiven Schicht (130) eine amorphe Struktur aufweist und wobei der Abschnitt der aktiven Schicht (130), der die Keimschicht (120) berührt, durch die Wärmebehandlung in eine kristalline Struktur umgewandelt wird.

15. Herstellungsverfahren nach Anspruch 13 oder 14, wobei eine Dicke der Keimschicht (120) 1 nm bis 10 nm ist und wobei eine Temperatur der Wärmebehandlung in einem Bereich von 300 °C bis 500 °C liegt, wobei das Ausführen der Wärmebehandlung vorzugsweise der Gleichung 1 genügt: $Y = 22 , 2 x + 277,8$ (1) wobei "x" die Dicke der Keimschicht (120) in nm ist und "Y" die Temperatur der Wärmebehandlung in °C ist.

## Revendications

1. Transistor à couches minces (100, 200, 300, 400, 500, 600, 700, 800, 900, 1000, 1100, 1200, 1300) comportant :
une couche de germe (120) présentant une structure amorphe ;
une couche active (130) chevauchant la couche de germe (120) et incluant une partie de canal (130n), dans lequel la partie de canal (130n) est en contact avec la couche de germe (120) et présente une structure cristalline ; et
une électrode de grille (150) chevauchant la couche de germe (120) et au moins une portion de la couche active (130) en vue de dessus du transistor à couches minces (100, 200, 300, 400, 500, 600, 700, 800, 900, 1000, 1100, 1200, 1300),
**caractérisé en ce qu'**une longueur de la couche de germe (120) est inférieure à une longueur de l'électrode de grille (150) le long d'une première direction (dr1).

2. Transistor à couches minces selon la revendication 1, dans lequel la partie de canal (130n) est disposée entre la couche de germe (120) et l'électrode de grille (150).

3. Transistor à couches minces selon la revendication 1 ou 2, dans lequel la couche active (130) inclut :
une première partie de connexion (130a) connectée à un premier côté de la partie de canal (130n) ; et
une seconde partie de connexion (130b) connectée à un second côté de la partie de canal (130n) qui est opposé au premier côté de la partie de canal (130n),
dans lequel la première partie de connexion (130a) et la seconde partie de connexion (130b) présentent chacune une structure amorphe qui est différente de la structure cristalline de la partie de canal (130n).

4. Transistor à couches minces selon la revendication 3, dans lequel une largeur de la couche de germe (120) est supérieure à une largeur de la couche active (130) le long d'une seconde direction qui est différente de la première direction ; et/ou
dans lequel une concentration de porteurs de la couche de germe (120) est inférieure à une concentration de porteurs de la partie de canal (130n), à une concentration de porteurs de la première partie de connexion (130a) et à une concentration de porteurs de la seconde partie de connexion (130b), dans lequel la concentration de porteurs de la couche de germe (120) est de préférence de 1,0 × 10¹⁶ cm⁻³ ou moins.

5. Transistor à couches minces selon l'une quelconque des revendications précédentes, dans lequel une épaisseur de la couche de germe (120) est dans une plage de 1 nm à 10 nm ;
dans lequel la structure amorphe de la couche de germe (120) inclut des cristallites ayant une taille de grain de 1 nm ou plus, dans lequel un rapport d'une somme d'aires des cristallites ayant la taille de grain de 1 nm ou plus est de 10 % ou moins sur la base d'une aire de section transversale complète de la couche de germe (120) ; et/ou
dans lequel, dans la partie de canal (130n), un rapport d'une somme d'aires de cristallites ayant une taille de grain de 1 nm ou plus est de 50 % ou plus sur la base d'une aire de section transversale complète de la partie de canal (130n).

6. Transistor à couches minces selon l'une quelconque des revendications précédentes, dans lequel la couche de germe (120) inclut au moins un matériau parmi un matériau semi-conducteur d'oxyde à base d'oxyde d'indium et de zinc (InZnO), un matériau semi-conducteur d'oxyde à base d'oxyde d'indium, de gallium et de zinc IGZO (InGaZnO), un matériau semi-conducteur d'oxyde à base d'oxyde d'indium, de gallium, de zinc et d'étain (InGaZnSnO), un matériau semi-conducteur d'oxyde à base d'oxyde de gallium, de zinc et d'étain (GaZnSnO), un matériau semi-conducteur d'oxyde à base d'oxyde de gallium et de zinc (GaZnO) et un matériau semi-conducteur d'oxyde à base d'oxyde de gallium (GaO).

7. Transistor à couches minces selon l'une quelconque des revendications précédentes, dans lequel la couche active (130) inclut au moins un matériau parmi des matériaux semiconducteurs à base d'oxyde d'indium, de gallium et de zinc (InGaZnO), à base d'oxyde d'indium et de gallium (InGaO), à base d'oxyde d'indium, de gallium, de zinc et d'étain (InGaZnSnO), à base d'oxyde de gallium, de zinc et d'étain (GaZnSnO), à base d'oxyde de gallium et de zinc (GaZnO), à base d'oxyde de gallium (GaO), à base d'oxyde d'étain (SnO), à base d'oxyde d'indium et d'étain (InSnO), à base d'oxyde d'indium, d'étain et de zinc (InSnZnO), à base d'oxyde d'indium et de zinc (InZnO), à base d'oxyde de zinc (ZnO), à base d'oxyde d'indium (InO), à base d'oxyde de zinc (ZnO) et à base d'oxyde de fer, d'indium et de zinc (FeInZnO), dans lequel la couche active (130) inclut en outre de préférence au moins un élément parmi le béryllium (Be), le bore (B), le carbone (C), l'aluminium (Al), le silicium (Si), le fer (Fe), le calcium (Ca), l'étain (Sn), le titane (Ti), le tantale (Ta), le vanadium (V), l'yttrium (Y) et le zirconium (Zr).

8. Transistor à couches minces selon l'une quelconque des revendications précédentes, dans lequel la couche de germe (120) et la couche active (130) incluent au moins un même élément métallique.

9. Transistor à couches minces selon l'une quelconque des revendications précédentes, dans lequel la structure cristalline de la partie de canal inclut au moins un plan parmi un plan cristallin (400), un plan cristallin (222), un plan cristallin (220), un plan cristallin (311) ou un plan cristallin (001).

10. Transistor à couches minces selon l'une quelconque des revendications précédentes, dans lequel la couche de germe (120) inclut un premier motif (121) et un second motif (121) qui sont espacés l'un de l'autre et chevauchent l'électrode de grille (150), dans lequel la couche active (130) est disposée entre le premier motif (121) et le second motif (122), dans lequel la couche active (130) est en contact avec le premier motif (121) et le second motif (122),
dans lequel la partie de canal (130n) inclut de préférence :
un premier canal (130n1) en contact avec le premier motif (121) ; et
un second canal (130n2) en contact avec le second motif (122).

11. Transistor à couches minces selon l'une quelconque des revendications précédentes, dans lequel la couche de germe (120) a au moins un trou d'interconnexion (120r) qui chevauche l'électrode de grille (150), dans lequel une portion de la couche active (130) est disposée dans le au moins un trou d'interconnexion (120r) ; et/ou
dans lequel la couche active (130) inclut :
une première couche semi-conductrice d'oxyde (131) ; et
une seconde couche semi-conductrice d'oxyde (132) disposée sur la première couche semi-conductrice d'oxyde (131),
dans lequel la couche de germe (120) est formée entre la première couche semi-conductrice d'oxyde (131) et la seconde couche semi-conductrice d'oxyde (132).

12. Appareil d'affichage (1400) comportant :
le transistor à couches minces selon l'une quelconque des revendications précédentes.

13. Procédé de fabrication d'un transistor à couches minces (100, 200, 300, 400, 500, 600, 700, 800, 900, 1000, 1100, 1200, 1300) comportant les étapes consistant à :
former une couche de germe (120) sur un substrat (110) ;
former une couche active (130) chevauchant la couche de germe (120) de telle sorte qu'une portion de la couche active (130) est en contact avec la couche de germe (120) et une autre portion de la couche active (130) n'est pas en contact avec la couche de germe (120) ;
cristalliser la portion de la couche active (130) qui est en contact avec la couche de germe (120) par un traitement thermique de la couche active (130) ; et
former une électrode de grille (150) sur la couche active (130),
**caractérisé en ce qu'**une longueur de la couche de germe (120) est inférieure à une longueur de l'électrode de grille (150) le long d'une première direction (dr1).

14. Procédé de fabrication selon la revendication 13, dans lequel la couche active (130) présente une structure amorphe lors de la formation de la couche active (130) et la portion de la couche active (130) en contact avec la couche de germe (120) est transformée en une structure cristalline par le traitement thermique.

15. Procédé de fabrication selon la revendication 13 ou 14, dans lequel une épaisseur de la couche de germe (120) est de 1 nm à 10 nm et dans lequel une température du traitement thermique est dans une plage de 300 °C à 500 °C, dans lequel la réalisation du traitement thermique satisfait de préférence à une Équation 1 : [Équation 1] $Y = 22 , 2 x + 277,8$ où "x" est l'épaisseur de la couche de germe (120) en nm et la température du traitement thermique est "Y" en °C.
